# EUROPÄISCHE PATENTANMELDUNG

(11) **EP 3 309 854 A1**
(43) Veröffentlichungstag der Anmeldung: **18.04.2018**
(21) Anmeldenummer: 16194191.9
(22) Anmeldetag: 17.10.2016
(51) Int. Cl.: H01L 51/52

(54) **OLED UMFASSENDES LEUCHTMITTEL FÜR FAHRZEUGLEUCHTE**

(71) Anmelder: odelo GmbH, 70329 Stuttgart (DE)
(72) Erfinder: VOLLMER, Marco, 71332 Waiblingen (DE)
(74) Vertreter: Benninger, Johannes

(57) **Zusammenfassung**

Es werden ein Leuchtmittel (01) und ein Verfahren zu dessen Herstellung beschrieben. Das Leuchtmittel (01) umfasst mindestens eine OLED (20) als Lichtquelle. Die OLED (20) besteht aus wenigstens einem Stapel umfassend organisch halbleitende Materialien mit mindestens einer zwischen elektrisch leitenden Schichten für Anode und Kathode eingeschlossen Emitterschicht. Die OLED (20) ist Teil eines OLED-Plättchens (02), bei dem der wenigstens eine Stapel zumindest vorder- und rückseitig verkapselt ist. Das OLED-Plättchen (02) weist eine Vorderseite (21), eine Rückseite (22) sowie einen dessen Vorder- und Rückseite (21, 22) verbindenden Rand (23) auf. Das OLED-Plättchen (02) ist zumindest an einem Teil seines Rands (23) von einer Kunststoffhalterung (03), welche wenigstens zum Teil aus einem zumindest im für das menschliche Auge sichtbaren Teil des elektromagnetischen Spektrums transparenten Material besteht, umspritzt und/oder umgossen. An der das OLED-Plättchen (02) zumindest an einem Teil seines Rands (23) umgebenden Kunststoffhalterung (03) ist mindestens eine Auskoppeloptik (25) angeordnet.

## Beschreibung

Die Erfindung betrifft ein mindestens eine OLED als Lichtquelle umfassendes Leuchtmittel gemäß dem Oberbegriff des Anspruchs 1.

Als Lichtquellen kommen in Fahrzeugleuchten Glühlampen, Gasentladungslampen sowie unter anderem wegen ihres wesentlichen Vorzugs einer wesentlich höheren Lichtausbeute bei gleicher Leistungsaufnahme vermehrt anorganische Leuchtdioden (LEDs) zum Einsatz.

Die Verwendung organischer Leuchtdioden (Organic Light Emitting Diode; OLED) statt LEDs als Lichtquellen verspricht nicht nur den selben wesentlichen Vorzug, sondern darüber hinausgehende Vorteile.

Eine OLED ist ein leuchtendes Dünnschichtbauelement aus organischen halbleitenden Materialien, das sich von den LEDs dadurch unterscheidet, dass keine einkristallinen Materialien erforderlich sind. Im Vergleich zu anorganischen LEDs lassen sich OLEDs daher in kostengünstiger Dünnschichttechnik herstellen. OLEDs ermöglichen dadurch die Herstellung flächiger Lichtquellen, die einerseits sehr dünn und andererseits als durch die Lichtscheibe einer Fahrzeugleuchte hindurch sichtbare leuchtende Fläche eingesetzt einen besonders homogenes Erscheinungsbild aufweisen.

OLEDs bestehen aus wenigstens einem Stapel umfassend organisch halbleitende Materialien mit mindestens einer zwischen elektrisch leitenden, beispielsweise metallischen Schichten für Anode und Kathode eingeschlossen Emitterschicht. OLEDs weisen eine Schichtstapelhöhe in der Größenordnung von etwa 100 nm auf.

Um in Fahrzeugleuchten einsetzbar zu sein, müssen OLEDs den an Fahrzeugkomponenten von und innerhalb Fahrzeugleuchten gestellten und während deren Entwicklung beispielsweise vermittels Shakerprüfung, chemische und mechanische Exposition sowie Klimakammer simulierten und in Form von technischen Anforderungen formulierten Einsatzbedingungen bezüglich thermischen, mechanischen und weiteren, auch kombinierten Umweltbelastungen, wie etwa Schadgas, Feuchtigkeit, Feuchte zusammen mit Wärme, Feuchte zusammen mit Frost, gerecht werden.

Zur Verwendung in Fahrzeugleuchten ist der oder sind die Stapel zum Schutz gegen Wasser, Sauerstoff sowie zum Schutz gegen andere Umwelteinflüsse, wie etwa Kratzbeschädigung und/oder Druckbelastung, mit einem anorganischen Material, insbesondere mit Glas verkapselt.

Zwar gibt es Anstrengungen, das Glas durch Kunststoff zu ersetzen, die jedoch nicht vom gewünschten Erfolg gekrönt sind, weil die Dichtigkeit der alternativen Materialien für die Verkapselung zumindest noch nicht ausreichend gut genug ist.

Zur Verwendung in Fahrzeugleuchten vorgesehene OLEDs werden daher bislang auf Glasplättchen als Trägermaterial aufgebracht. Glas weist eine für die organischen Schichten von OLEDs vorteilhafte geringe Gasdurchlässigkeit auf, so dass das Trägermaterial zugleich eine Schutzschicht bildet.

Die zur Verkapselung der Schichtstapel vorgesehenen Glasplättchen sind mit jeweils etwa 0,7 bis 1,2 mm relativ dünn und damit auch relativ zerbrechlich. Vor allem sind auch die Glasaußenkanten empfindlich gegen mechanische Belastungen und können leicht ausbrechen.

Teilweise sind die Glasplättchen sogar noch dünner, sofern keine Dünnschichtverkapselung in den Schichtstapel zugefügt wird, da dann mit einem Kavitätsglas gearbeitet wird. Dabei wird das Glas auf der Kathode beispielsweise ausgefräst, um den so genannten Getter unterzubringen, dessen Aufgabe es ist, Feuchtigkeit, die beispielsweise durch Diffusion durch die Kleberschicht zwischen den zwei Glasplatten eintreten kann, im Inneren der OLED aufzunehmen und die organischen Schichten hiervor zu schützen.

Das Kavitätsglas hat damit im mittleren Bereich Dicken von etwa 0,5 mm und weniger und ist damit sehr empfindlich gegen Druckbelastungen. Auch darf durch Druckbelastung der Getter, der in entsprechend ausgeführten OLEDs mit etwas Abstand zu den organischen Schichten angeordnet ist, nicht auf die organischen Schichten drücken, da hierdurch die wenige Nanometerdicken Schichten beschädigt werden könnten, was zu einem teilweisen oder totalen Ausfall der OLED führen würde.

Hinsichtlich der Einsatzbedingungen sowie des Umgangs während der Montage sind OLEDs daher einer hohen Zerstörungsgefahr ihrer Glasplättchen ausgesetzt.

Die mit Glasplättchen aufgebauten, kurz als OLED-Plättchen bezeichneten OLEDs müssen daher möglichst frei von mechanischen Spannungen (spannungsfrei) und Momenten (momentfrei) in einer Fahrzeugleuchte aufgenommen und gehalten werden.

Eine sich hieraus ergebende technische Anforderung sieht vor, die zur Verwendbarkeit in Fahrzeugleuchten vermittels beispielsweise aus Glas hergestellten Deckschichten gekapselten OLEDs beschädigungsfrei gegenüber während der Montage und im Fahrbetrieb auftretenden mechanischen Beanspruchungen zu fassen und zu halten.

Zur Halterung werden die OLED-Plättchen bislang mittels doppelseitigem Klebeband oder Flüssigkleber oder anderen geeigneten Klebern beispielsweise auf Kunststoffträger manuell aufgeklebt.

Hierbei kann eine einen nichtabstrahlenden Bereich darstellende Rückfläche eines OLED-Plättchens aus Metall oder Glas ausgeführt sein. Auch sind transparente Bereiche in der OLED möglich, allerdings mit dem Nachteil, dass dann die Klebefläche in diesem Bereich ausgespart sein muss und damit die Haltekraft verringert wird. Eine andere Lösung ist, den Kleber auch im Transparentbereich einer OLED auszuführen, die dann vollflächig mit einem Kunststoffträger verklebt wird. Dann ist aber ein direkter Blick auf den Kleber gegeben, mit dem Nachteil, dass unter Anderem auch qualitativ nicht so hochwertige Klebereinschlüsse wie Blasen oder Staub sichtbar werden, einhergehend mit einer unerwünschten, nachteiligen Beeinträchtigung der Abgabe des von der OLED abgestrahlten Lichts und einer damit nur eingeschränkten, das Verhältnis des in einer gewünschten Lichtverteilung von einer Lichtquelle abgegebenen Lichts zu dem von der Lichtquelle insgesamt ausgestrahlten Licht widerspiegelnden optischen Güte.

Ein besonderer Nachteil ergibt sich in Verbindung mit einer Verwendung in Fahrzeugleuchten durch die dort auftretenden Schwingungsbelastungen einhergehend mit extremen klimatischen Bedingungen im Leuchteninnenraum, welche eine zuverlässige, dauerhafte Halterung der OLED-Plättchen erfordern. Dies ist durch ein flächiges Verkleben nicht sichergestellt, beispielsweise aufgrund der Alterung der Klebeverbindung, um nur eine Einschränkung hinsichtlich der Zuverlässigkeit der dauerhaften Halterung explizit anzuführen.

In Fahrzeuganwendungen sowie in Verbindung mit einer Verwendung in Fahrzeugleuchten hat dies zusätzlich zu dem genannten eingeschränkten Qualitätseindruck und der verminderten Haltbarkeit den generellen Nachteil hoher, nicht serientauglicher Fertigungskosten.

Dem Stand der Technik gemein ist, dass ungeachtet der damit verfolgten hehren Ziele die voranstehenden Ausführungen zum Aufbau und damit auch zum notwendigen Walten von Vorsicht beim Umgang von OLEDs insbesondere bei deren Verwendung in Fahrzeugleuchten keinerlei Beachtung finden.

Durch EP 2 592 331 A1 ist eine Fahrzeugleuchte mit einer vermittels eines Halters im Leuchteninnenraum untergebrachten OLED bekannt. Der Halter ist dabei als ein die OLED zumindest bereichsweise umgebender Rahmen ausgeführt. Zum Schutz ihrer Glasplättchen vor Zerstörung durch Vibrationen kann dabei vorgesehen sein, zwischen dem Halter und der OLED ein Elastomer anzuordnen. Offen bleibt hierbei, wie die OLED spannungsfrei gehalten werden soll, damit ihre Glasplättchen nicht zerstört und/oder beschädigt werden.

Durch DE 10 2009 009 087 A1 ist bekannt, im Leuchteninnenraum einer Fahrzeugleuchte eine OLED als Lichtquelle eines zur Erfüllung einer zweiten Lichtfunktion vorgesehenen Leuchtmittels im Strahlengang zwischen einem zur Erfüllung einer ersten Lichtfunktion vorgesehenen Leuchtmittels und einer Lichtscheibe anzuordnen. Die OLED ist dabei zwischen zwei Klammern einer Halterung gespannt. Eine spannungsfreie Halterung der OLED zum Schuz deren Glasplättchen vor Zerstörung und/oder Beschädigung ist damit nicht sichergestellt.

Durch DE 20 207 799 U1 ist eine Fahrzeugleuchte mit einer auf einem Träger aufsitzenden Lichtscheibe und einer zwischen Lichtscheibe und dem Träger angeordneten OLED bekannt.

Durch DE 10 2007 021 179 A1 ist bekannt, eine OLED in eine transparente, einen Leuchteninnenraum begrenzende Rückwand einer Fahrzeugleuchte zu integrieren.

Durch DE 10 2005 024 838 A1 ist ein für den Innen- oder Außenbereich eines Kraftfahrzeugs vorgesehenes Leuchtmittel mit einer OLED als Lichtquelle bekannt. Das Leuchtmittel umfasst eine auf einem Träger angeordnete OLED. Die OLED ist beispielsweise durch Aufkleben mit einem flächigen Träger verbunden. Der beispielsweise im Spritzguss hergestellte Träger weist ein Anschlussmittel auf, mit dem das Leuchtmittel mit dem Kraftfahrzeug elektrisch und mechanisch verbindbar ist. Das Anschlussmittel in Form eines Zapfens mit Rastmitteln ist mittig auf der Rückseite des Trägers angeordnet. Nachteilig hieran ist, dass beim Ein- und Ausstecken des Trägers damit die Gefahr einer Zerstörung der die Vorder- und Rückseiten der OLED bildenden Glasplättchen besteht.

Durch US 2011/089811 A1 ist ein Leuchtmittel mit einer OLED als Lichtquelle bekannt. Die OLED ist auf einem gekrümmten Träger angeordnet. Der Träger wird mit der Krümmung hergestellt. Die ebene OLED wird auf den Träger aufgebracht, indem dieser elastisch in ebene Form gebracht wird. Nach dem Aufbringen der OLED wird die elastische Verformung des Trägers aufgehoben, so dass der OLED die Krümmung des Trägers aufgezwungen wird. Nachteilig hieran ist, dass die OLED nicht frei von mechanischen Spannungen gehalten ist und dadurch die Gefahr einer Zerstörung des zumindest einen als Basis der OLED dienenden Glasplättchens besteht.

Durch EP 2 592 331 A1 ist bekannt, dass ein OLED-Plättchen bei einem Leuchtmittel mit mindestens einer OLED als Lichtquelle zumindest an einem Teil seines Rands von einer Kunststoffhalterung umgeben ist. Zumindest Teil diesen OLED-Plättchens ist eine OLED, die aus wenigstens einem Stapel umfassend organisch halbleitende Materialien mit mindestens einer zwischen elektrisch leitenden Schichten für Anode und Kathode eingeschlossen Emitterschicht besteht. Bei dem OLED-Plättchen ist der wenigstens eine Stapel zumindest vorder- und rückseitig verkapselt. Das OLED-Plättchen weist eine Vorderseite, eine Rückseite sowie einen dessen Vorder- und Rückseite verbindenden Rand auf.

Durch WO 2010/116300 A1 ist bekannt, zumindest die Ecken und/oder Kanten eines OLED-Plättchens mit einem weichen Rand zu bedecken. Der Rand kann aus einem Kunststoff bestehen.

Aufgrund der bestehenden Nachfrage nach Fahrzeugleuchten mit OLEDs als Lichtquellen, der bestehenden Probleme der Halterung von OLEDs in Fahrzeugleuchten, der bestehenden, nicht serientauglichen Befestigungsmethoden von OLEDs auf spritzgegossenen Kunststoffträgern und der bislang nur unzureichend gelösten Vibrationsfestigkeit der bestehenden Halterungen müssen Maßnahmen getroffen werden, damit auch Leuchtmittel mit OLEDs als Lichtquellen für den Einsatz in Fahrzeugleuchten den an Fahrzeugleuchten und alle in diesen verbauten Komponenten gestellten technischen Anforderungen gerecht werden können.

Darüber hinaus besteht ein Nachteil des Standes der Technik bezüglich des Einsatzes von OLEDs als Lichtquellen von zur Erfüllung von Lichtfunktionen einer Heckleuchte für ein Kraftfahrzeug vorgesehenen Leuchtmitteln in einem unkontrollierten Lichtaustritt an deren umlaufenden Kanten.

Hierdurch können OLEDs zumindest nicht ohne weitere Maßnahmen nicht für jede Lichtfunktion eingesetzt werden, sei es, weil einzelne Lichtfunktionen eine Lichtverteilung mit einer Lichtabstrahlung mit vorgegebenen Lichtstärken in von den Kanten eingenommenen Raumwinkelbereichen erfordern, oder weil sie zumindest in einem Teil dieser Raumwinkelbereiche eine Lichtabstrahlung verbieten.

Eine Aufgabe der Erfindung ist, ein Leuchtmittel mit mindestens einer OLED als Lichtquelle zu entwickeln, welches den an Fahrzeugleuchten und alle in diesen verbauten Komponenten gestellten technischen Anforderungen gerecht wird und darüber hinaus den Einsatzbereich von OLEDs als Lichtquellen auch für solche Leuchtmittel ermöglicht, welche einer Erfüllung einer oder mehrerer Lichtfunktionen beitragen, welche eine Lichtabstrahlung mit vorgegebenen Lichtstärken in von den Kanten eingenommenen Raumwinkelbereichen erfordern, oder weil sie zumindest in einem Teil dieser Raumwinkelbereiche eine Lichtabstrahlung verbieten.

Die Aufgabe wird gelöst durch die Merkmale des unabhängigen Anspruchs. Vorteilhafte Ausführungsformen sind in den Ansprüchen, den Zeichnungen sowie in der nachfolgenden Beschreibung, einschließlich der zu den Zeichnungen zugehörigen, wiedergegeben.

Die Erfindung betrifft demnach ein bevorzugt in Verbindung mit einer Fahrzeugleuchte zur Verwendung vorgesehenes Leuchtmittel. Das Leuchtmittel umfasst wenigstens eine OLED als Lichtquelle. Die OLED besteht aus wenigstens einem Stapel umfassend organisch halbleitende Materialien mit mindestens einer zwischen elektrisch leitenden, beispielsweise metallischen Schichten für Anode und Kathode eingeschlossen Emitterschicht. Der oder die Stapel sind zum Schutz gegen Wasser, Sauerstoff sowie zum Schutz gegen andere Umwelteinflüsse, wie etwa Kratzbeschädigung und/oder Druckbelastung zumindest vorder- und rückseitig beispielsweise vorzugsweise mit einem anorganischen Material, insbesondere mit Glas verkapselt. Eine der rückseitigen Verkapselung dienende Schicht kann beispielsweise aus einem Metall oder einer Metalllegierung hergestellt sein oder bestehen. Alternativ oder zusätzlich können zur vorder- und/oder rückseitigen Verkapselung dienende Glasplättchen und/oder Kunststoffplättchen an ihrer den organischen Schichten im Inneren der OLED abgewandten Außenseite andere Materialien aufweisen, wie etwa Aluminium zur Wärmeleitung und -spreitzung.

Die wie zuvor beispielhaft beschrieben aufgebaute, kurz als OLED-Plättchen bezeichnete OLED weist eine Vorderseite, eine Rückseite sowie einen dessen Vorder- und Rückseite verbindenden, umlaufenden Rand auf.

Das OLED-Plättchen ist zumindest an seinen Rändern oder einem Teil seines umlaufenden Rands von einer Kunststoffhalterung aus einem für das von der OLED abgegebene Licht zumindest weitgehend transparenten Material umspritzt und/oder umgossen.

Die Kunststoffhalterung bildet damit eine zumindest an einem Teil des umlaufenden Rands des OLED-Plättchens dieses umgebende Kunststoffumrandung. Die Kunststoffumrandung umgibt den Rand des OLED-Plättchens zumindest abschnittsweise entlang derjenigen Partien des umlaufenden Rands, in denen das OLED-Plättchen von der Kunststoffumrandung umspritzt und/oder umgossen ist.

Der umlaufende Rand des OLED-Plättchens erstreckt sich hierbei zumindest zwischen den beiden jeweils die Vorder- und Rückseite des OLED-Plättchens begrenzenden, umlaufenden Kanten des OLED-Plättchens.

An der das OLED-Plättchen zumindest an einem Teil seines umlaufenden Rands umgebenden Kunststoffhalterung ist mindestens eine an den von der Kunststoffhalterung umgebenen Kanten des OLED-Plättchens austretendes Licht in eine vorgegebene oder erwünschte Richtung umlenkende Auskoppeloptik angeordnet.

Die Erfindung sieht demnach vor, dass an einem wenigstens einen Teil der Kanten einer OLED einnehmenden, angespritzten Halter, der wenigstens zum Teil aus einem zumindest im für das menschliche Auge sichtbaren Teil des elektromagnetischen Spektrums transparenten Material besteht, Auskoppeloptiken vorgesehen sind, welche an den Kanten der OLED an deren mit dem Halter versehenen Rändern austretendes Licht in einer gewünschten Richtung umlenken.

Es ist ersichtlich, dass die Erfindung verwirklicht sein kann, indem an das die OLED umgossene und/oder umspritzte -vorzugsweise transparente oder semitransparente- Material der Kunststoffhalterung Auskoppeloptiken mit einer oder mehreren optischen Oberflächen angeformt sind. Diese können im Randbereich der OLED austretendes Licht entsprechend des ausgelegten Optik-Designs in das gewünschte Zielgebiet lenken. Dies kann insbesondere sinnvoll sein, wenn eine vermittels eines eine rotes Licht abstrahlenden OLED als Lichtquelle umfassenden Leuchtmittels zu erfüllende Lichtfunktion beispielsweise eine Abstrahlung roten Lichts nach vorn verbietet, oder eine seitliche Lichtverteilung für eine Seitenmarkierungslichtfunktion erfüllt werden soll mit beispielsweise den OLEDs für eine Schlusslichtfunktion.

Die Erfindung behebt den Nachteil des Standes der Technik eines unkontrollierten Lichtaustritts an den umlaufenden Kanten eines OLED-Plättchens, indem an einem wenigstens einen Teil der Kanten einnehmenden, angespritzten Halter, welcher wenigstens zum Teil aus einem zumindest im für das menschliche Auge sichtbaren Teil des elektromagnetischen Spektrums transparenten Material besteht, Auskoppeloptiken vorgesehen sind, welches an den Kanten der OLED an deren mit dem Halter versehenen Rändern austretendes Licht in einer gewünschten Richtung umlenken..

Hierdurch können OLEDs ohne weiteres für jede Lichtfunktion eingesetzt werden, sei es, solche Lichtfunktionen, die eine Lichtverteilung mit einer Lichtabstrahlung mit vorgegebenen Lichtstärken in von den Kanten eingenommenen Raumwinkelbereichen erfordern, oder solche Lichtfunktionen, die zumindest in einem Teil dieser Raumwinkelbereiche eine Lichtabstrahlung verbieten.

Die Erfindung schafft so eine Erweiterung der Einsatzmöglichkeiten von OLEDs als Lichtquellen von zur Erfüllung von Lichtfunktionen beispielsweise einer Heckleuchte für ein Kraftfahrzeug vorgesehenen Leuchtmitteln.

Darüber hinaus schafft die Erfindung ein Leuchtmittel mit einem dauerhaft und sicher von der Kunststoffhalterung aufgenommenen OLED-Plättchen als Lichtquelle, welches den an Fahrzeugleuchten und alle in diesen verbauten Komponenten gestellten technischen Anforderungen gerecht wird, indem auf Glasplättchen als Trägermaterial aufgebrachte OLEDs in Fahrzeugleuchten beherbergt werden, indem diese von wenigstens zwei gegenüberliegenden Rändern der OLED her zumindest teilweise mit einem Halter umspritzt sind. Ein solcher Halter ist dauerhaft mit der OLED verbunden und unterliegt keiner beschleunigten Alterung, wie dies bei Klebeverbindungen durchaus der Fall ist. Ferner kann die auf absehbare Zeit nicht durch andere Materialien ersetzbare Glasplatte vibrationssicher gehalten werden.

In einer Draufsicht normal zur Vorder- und Rückseite des OLED-Plättchens gesehen ist dieses nicht zwingend allseitig an seinem gesamten umlaufenden Rand von der Kunststoffumrandung umspritzt und/oder umgossen. In denjenigen Partien des umlaufenden Rands, in denen das OLED-Plättchen von der Kunststoffumrandung umspritzt und/oder umgossen ist, umgibt die Kunststoffumrandung in einem normal zur Vorder- und Rückseite des OLED-Plättchens verlaufenden Querschnitt den Rand vollständig und kann zugleich Teile der Vorder- und/oder Rückseite des OLED-Plättchens bedecken.

Das OLED-Plättchen kann in einer Draufsicht normal zur Vorder- und Rückseite des OLED-Plättchens von drei Seiten her, beispielsweise C-förmig von der Kunststoffhalterung umspritzt und/oder umgossen sein. Auch eine gabelförmige Umspritzung oder Umgießung, bei der das OLED-Plättchen zwischen zwei Zinken einer gabelförmigen Kunststoffhalterung angeordnet ist, ist denkbar.

Auch eine allseitige Umspritzung oder Umgießung des OLED-Plättchens um dessen gesamten, umlaufenden Rand herum ist denkbar.

Zusätzlich kann das OLED-Plättchen vorder- oder rückseitig ganz oder teilweise von der Kunststoffhalterung umspritzt und/oder umgossen sein.

Beispielsweise kann die OLED zusätzlich vollflächig von deren Rückseite angespritzt oder angegossen sein.

Zusammengefasst kann die OLED von drei Seiten her, beispielsweise C-förmig umspritzt werden. Auch eine allseitige Umspritzung ist denkbar. Ferner kann die OLED vollflächig von deren Rückseite zusätzlich angespritzt sein.

Alle genannten Umspritzungen können in einem Spritzgussverfahren hergestellt werden, welches neben der Anformung der Umspritzung eine aktive Kühlung der OLED während des Spritzgussvorgangs vorsieht, um schädigende Temperatureinwirkungen von den organischen Schichten der OLED fernzuhalten.

Ist die Kunststoffhalterung vollständig aus einem zumindest im für das menschliche Auge sichtbaren Teil des elektromagnetischen Spektrums transparenten Kunststoff hergestellt, so kann das OLED-Plättchen vorder- und rückseitig jeweils ganz oder teilweise von der Kunststoffhalterung umspritzt und/oder umgossen sein.

Definiert dabei die Vorderseite des OLED-Plättchens eine Seite, in welcher Licht abgestrahlt werden soll, und die Rückseite eine Seite, in der eine Lichtabstrahlung nicht erforderlich und/oder gar unerwünscht ist, so sind die voranstehenden Ausführungen zur gegebenenfalls vorgesehenen vorder- und/oder rückseitigen Umspritzung oder Umgießung dahingehend definiert, dass das OLED-Plättchen rückseitig ganz oder teilweise mit einem opaken Material der Kunststoffhalterung umspritzt und/oder umgossen sein kann, wohingegen das OLED-Plättchen auf seiner Vorderseite und an dessen umlaufendem Rand nur von einer Kunststoffhalterung aus einem zumindest im für das menschliche Auge sichtbaren Teil des elektromagnetischen Spektrums transparenten Kunststoff ganz oder teilweise umspritzt und/oder umgossen sein darf. Wichtig ist hierbei hervorzuheben, dass eine Kombination aus opakem Kunststoff auf der Rückseite und transparentem Kunststoff auf der Vorderseite und am Rand durch Umspritzung oder Umgießung in einem mehrstufigen Spritzgussprozess denkbar ist.

Zur besseren Füllung der Kunststoffhalterung während des Umspritzens und/oder Umgießens des OLED-Plättchens mit Kunststoff-Material können Fließhilfen in Form von beispielsweise Rippen an der Kunststoffhalterung vorgesehen sein.

Ein Leuchtmittel mit mindestens einer eine zumindest an ihren Rändern oder einem Teil ihres umlaufenden Rands von einer Kunststoffhalterung umspritzte oder umgossene OLED umfassenden Lichtquelle kann darüber hinaus über ein oder mehrere Elektronikbauteile verfügen.

Die Notwendigkeit, ein oder mehrere Elektronikbauteile dem Leuchtmittel zuzuordnen, kann sich aus dem Umstand ergeben, dass zum Betrieb von OLEDs als Lichtquellen für ein Leuchtmittel beispielsweise einer Fahrzeugleuchte eine oder mehrere mehr oder minder komplexe elektronische Steuerschaltungen vorgesehen sein können.

Somit kann ein Leuchtmittel mit einer oder mehreren OLEDs als Lichtquelle meist zusätzlich zu einer oder mehreren aufgrund ihres Diodenaufbaus Elektronikbauteile darstellenden OLEDs zumindest ein weiteres Elektronikbauteil umfassen. Demnach kann ein Leuchtmittel mit einer oder mehreren OLEDs als Lichtquellen neben der mindestens einen OLED zumindest noch über ein weiteres Elektronikbauteil verfügen.

Zu deren elektrischer Kontaktierung und mechanischen Befestigung sowie zur elektrischen Verbindung der mindestens einen OLED mit einem oder mehreren Elektronikbauteilen und/oder zur elektrischen Weiterkontaktierung wenigstens einer OLED kann die beispielsweise spritzgegossene Kunststoffhalterung als ein in MID-Technik (MID-Technik: Molded-Interconnect-Device-Technik) hergestellter Leiterbahnträger ausgeführt sein, zumindest ein Teil dessen Leiterbahnen mit den elektrischen Anschlüssen des mindestens einen OLED-Plättchens elektrisch verbunden und/oder elektrisch verbindbar sind. Damit erfüllt die Kunststoffhalterung gleichzeitig mehrere Funktionen, erstens die spannungs- und momentenfreie Halterung des mindestens einen OLED-Plättchens, zweitens die elektrische Kontaktierung des OLED-Plättchens und drittens die elektrische Weiterverbindung des OLED-Plättchens mit einer auf dem spritzgegossenen Schaltungsträger angeordneten, durch mindestens ein mit den Leiterbahnen des in MID-Technik hergestellten Leiterbahnträgers verbundenes oder verbindbares Elektronikbauteil gebildeten elektronischen Steuerschaltung.

Ein in MID-Technik hergestellter Leiterbahnträger stellt eine Ausführung spritzgegossener Schaltungsträger dar, welche in Gestalt eines Bauteils beispielsweise einer Fahrzeugleuchte mit integrierten Leiterbahnen in Spritzgusstechnik hergestellt werden und neben ihrer Funktion zur elektrischen Kontaktierung beispielsweise von Elektronikbauteilen und/oder Lichtquellen gleichzeitig eine mechanische Funktion der Fahrzeugleuchte übernehmen, beispielsweise eine Anordnung von Lichtquellen entlang einer vorgegebenen Geometrie unter gleichzeitiger Ausbildung eines Reflektors.

Mittels eines zuvor beschriebenen Leuchtmittels können OLEDs in Fahrzeugleuchten eingebaut und im Fahrbetrieb eines Fahrzeugs eingesetzt werden, ohne dass eine ansonsten ständig vorhandene Bruchgefahr deren zum Schutz gegen Umwelteinflüsse zur Verkapselung benötigten Glasplättchen besteht.

Es ist ersichtlich, dass die Erfindung die gestellte Aufgabe durch eine Fassung löst, welche hergestellt ist, indem mindestens ein OLED-Plättchen wenigstens teilweise von einer Kunststoffhalterung umspritzt ist, die zumindest im Bereich des von ihr umgriffenen Rands transparent ist. Im Bereich des von ihr umgriffenen Rands ist die Fassung mit einer oder mehreren, an den von der Kunststoffhalterung umgebenen Kanten des OLED-Plättchens austretendes Licht in eine vorgegebene oder erwünschte Richtung umlenkenden Auskoppeloptiken versehen.

Die Kunststoffhalterung kann an einem oder an wenigstens zwei gegenüberliegenden Rändern der OLED angespritzt sein. Eine solche Fassung ist dauerhaft mit der OLED verbunden und unterliegt keiner beschleunigten Alterung, wie dies bei Klebeverbindungen durchaus der Fall ist. Ferner kann die auf absehbare Zeit nicht durch andere Materialien ersetzbare Glasplatte vibrationssicher gehalten werden.

Ein Verfahren zur Herstellung eines zuvor beschriebenen, mindestens eine in Form eines OLED-Plättchens ausgeführte OLED als Lichtquelle umfassenden Leuchtmittels kann wie nachfolgend beschrieben ausgestaltet sein.

Das Verfahren sieht zunächst vor, mindestens ein OLED-Plättchen in eine Ausnehmung einer Form einzulegen, welche Form mindestens eine in der Ausnehmung ausgebildete Auflage für jedes OLED-Plättchen aufweist, und welche Ausnehmung in mindestens einer sich parallel zur Vorder- und Rückseite des OLED-Plättchens erstreckenden Richtung ein Maß aufweist, das größer ist, als die Erstreckung des OLED-Plättchens in dieser Richtung.

Die mindestens eine Auflage kann beispielsweise vollflächig eine einer Lichtabgabe, beispielsweise einer Hauptlichtabgabe dienende oder zur Lichtabgabe, beispielsweise Hauptlichtabgabe vorgesehene, Vorder- oder Rückseite des OLED-Plättchens bildende Oberfläche des OLED-Plättchens einnehmen. Das OLED-Plättchen wird hierbei mit der entsprechenden Oberfläche auf die mindestens eine Auflage in der Ausnehmung aufgelegt.

Alternativ oder zusätzlich kann die Auflage derart ausgebildet sein, dass das OLED-Plättchen an mindestens einem Randbereich auf der Auflage aufliegt. Ein entsprechender, auf der Auflage aufgelegter Randbereich bleibt hierbei frei von der Umspritzung oder Umgießung vermittels der Kunststoffhalterung.

Wichtig ist in diesem Zusammenhang zu erwähnen, dass das OLED-Plättchen bevorzugt frei von Kräften und Momenten auf die mindestens eine Auflage in der Ausnehmung aufgelegt wird und nur durch Formgebung der Ausnehmung und der Auflage während des Umspritzens und/oder Umgießens ortsfest gehalten wird.

Anschließend sieht das Verfahren vor, das OLED-Plättchen mit zunächst flüssigem Kunststoff zu umspritzen und/oder zu umgießen, wobei die Ausnehmung mit dem darin eingelegten OLED-Plättchen mit dem zunächst flüssigen Kunststoff verfüllt wird.

Daraufhin sieht das Verfahren vor, abzuwarten, bis der anfänglich flüssige Kunststoff verfestigt. Der Kunststoff kann durch Aufheizen in seinen zunächst flüssigen Zustand versetzt sein, wobei die Verfestigung durch eine Abkühlung erreicht wird. Alternativ oder zusätzlich kann ein chemischer Abbindevorgang während der Verfestigung des zunächst flüssigen Kunststoffs stattfinden.

Wichtig ist hervorzuheben, dass der zum Umspritzen verwendete Kunststoff zumindest in seinem abgekühlten, festen Zustand zumindest innerhalb eines Wellenlängenbereichs des von dem OLED-Plättchen innerhalb des für das menschliche Auge sichtbaren Teils des elektromagnetischen Spektrums abgegebenen Lichts transparent ist.

Schließlich sieht das Verfahren vor, das mindestens eine zumindest an seinen Rändern oder einem Teil seines umlaufenden Rands von einer Kunststoffhalterung umspritzte oder umgossene OLED-Plättchen umfassende Leuchtmittel der Form zu entnehmen.

Das Verfahren kann vorsehen, die Kunststoffhalterung durch Hinterspritzung einer Folie herzustellen, welche Folie mit einer eine Auskoppeloptik bildenden, vorgefertigten, beispielsweise durch Drucken und/oder Stanzen und/oder Tiefziehen hergestellten Struktur versehen sein kann. Hierbei sieht das Verfahren vor, zunächst eine entsprechend vorbereitete Folie in die Ausnehmung einer Form einzulegen, bevor das mindestens eine OLED-Plättchen ebenfalls in die Form eingelegt wird. Anschließend erfolgt das Umspritzen und die Entnahme aus der Form wie zuvor beschrieben.

Eine alternative oder zusätzliche Möglichkeit ergibt sich durch eine Erzeugung der mindestens einen Auskoppeloptik vermittels Laserstrukturierung. Dabei wird die mindestens eine Auskoppeloptik im Anschluss an die Entnahme aus der Form mittels Laserlichts in das transparente Material der Kunststoffhalterung eingearbeitet.

Das Verfahren kann vorsehen vor dem Umspritzen und/oder Umgießen des OLED-Plättchens die Ausnehmung bis auf wenigstens eine Eintragungs- oder Einbringungsöffnung für den zunächst flüssigen Kunststoff und bis auf wenigstens eine Austragungs- oder Entweichungsöffnung für von dem zunächst flüssigen Kunststoff während dessen Einbringens in die Ausnehmung verdrängte Luft zu verschließen. Die dabei verbleibende, die Ausnehmung umfassende oder von der Ausnehmung umfasste Kavität weist eine der äußeren Form des fertigen Leuchtmittels entsprechende Gestalt auf.

Damit die mindestens eine organische Schicht des OLED-Plättchens weder durch das Einbringen eines gegebenenfalls durch Erhitzen verflüssigten Kunststoffs in die Ausnehmung, noch durch einen gegebenenfalls stattfindenden exothermen chemischen Abbindevorgang beschädigt wird, kann das Verfahren vorsehen, das OLED-Plättchen zumindest während des Einbringens des zunächst flüssigen Kunststoffs in die Ausnehmung sowie während des Abwartens der Verfestigung des Kunststoffs zu kühlen. Dies kann erfolgen, indem die mindestens eine Auflage, auf der das OLED-Plättchen in der Ausnehmung aufliegt, gekühlt ist, beispielsweise durch einen in die Auflage eingearbeiteten Kanal eines Kühlkreislaufs, durch den ein Kühlmittel hindurchströmen, beispielsweise zirkulieren kann.

Alternativ oder zusätzlich kann die Kühlung durch einen Stempel erfolgen, der vor dem Einbringen des zunächst flüssigen Kunststoffs auf zumindest einen Teil der der mindestens einen Auflage abgewandten Oberfläche des OLED-Plättchens abgesenkt wird und in dieser Position verweilt, bis der Kunststoff verfestigt ist. Der Stempel kann gekühlt sein, beispielsweise passiv durch Ausnutzung dessen Wärmekapazität, wobei er wenn er nicht auf ein OLED-Plättchen abgesenkt ist, in ein kühleres Wärmeniveau zurückgezogen wird, oder aktiv, wobei der Stempel mit einem Kühlkreislauf in Wärmeübertragungsverbindung steht, beispielsweise indem in den Stempel mindestens ein Kanal eines Kühlkreislaufs eingearbeitet ist, durch den ein Kühlmittel hindurchströmen, beispielsweise zirkulieren kann.

Alle zuvor genannten, durch teilweise Umspritzung oder Umgießung mindestens eines OLED-Plättchens hergestellten Kunststoffhalterungen können demzufolge in einem Spritzgussverfahren hergestellt werden, welches neben der Anformung der Kunststoffhalterung eine aktive Kühlung der OLED während des Spritzgussvorgangs vorsieht, um schädigende Temperatureinwirkungen von den organischen Schichten der OLED fernzuhalten.

Das Verfahren kann zusätzlich vorsehen, dass die Ausnehmung eine Tiefe aufweist, welche größer ist, als eine durch die Erstreckung des OLED-Plättchens von dessen Vorderseite zu dessen Rückseite normal zu Vorder- und Rückseite gegebene Dicke des OLED-Plättchens, wobei die Ausnehmung während des Umspritzens und/oder Umgießens bis über das OLED-Plättchen gefüllt wird.

Das Verfahren kann vorsehen, vor oder nach dem Einlegen des OLED-Plättchens in die Form elektrische Anschlüsse der OLED beispielsweise durch Drahtbonden oder oder Anbinden einer Flexplatine beispielsweise mittels ACF(Anisotropic conductive film)-Bonden zu kontaktieren und mit der Weiterkontaktierung dienenden Leitern zu verbinden. Die Leiter können aus der Ausnehmung heraus geführt werden, bevor in einem späteren Verfahrensschritt das OLED-Plättchen mit zunächst flüssigem Kunststoff umspritzt und/oder umgossen wird.

Alternativ kann das Verfahren vor oder nach dem Einbringen des OLED-Plättchens in die Form vorsehen, die elektrischen Anschlüsse des OLED-Plättchens mit einer nachträglich entfernbaren Abdeckung zu schützen und von dem in einem späteren Verfahrensschritt, in dem das OLED-Plättchen mit zunächst flüssigem Kunststoff umspritzt und/oder umgossen wird, in die Ausnehmung verfüllten Kunststoff freizuhalten.

Das Verfahren kann alternativ oder zusätzlich vorsehen, gegebenenfalls mit elektrischen Anschlüssen des OLED-Plättchens verbundene oder verbindbare Leiterbahnen in die Ausnehmung einzubringen, welche dann in einem späteren Verfahrensschritt, in dem das OLED-Plättchen mit zunächst flüssigem Kunststoff umspritzt und/oder umgossen wird, ebenfalls von dem Kunststoff umspritzt und/oder umgossen werden.

Grundsätzlich kann das Verfahren zur gleichzeitigen Ausbildung von Leiterbahnen auf oder in der durch Umspritzen und/oder Umgießen des OLED-Plättchens mit zunächst flüssigem Kunststoff hergestellten Kunststoffhalterung eine oder mehrere Methoden der MID-Technik vorsehen, wie etwa Zweikomponentenspritzguss, MID-Heißprägen, Laser-Direkt-Strukturierung, Subtraktive Laserstrukturierung, Maskenbelichtungsverfahren, Folienhinterspritzen, Aufschmelzen eines kontinuierlich zugeführten Kupferdrahts und Aufspritzen auf die Trägermaterialien mit Druckluft. Die elektrischen Anschlüsse der OLED können im Anschluss an die Herstellung der Leiterbahnen beispielsweise durch Drahtbonden oder ACF-Bonden mit zumindest einem Teil der Leiterbahnen verbunden werden.

Wichtig ist hervorzuheben, dass wenn das Leuchtmittel mehrere OLED-Plättchen umfasst, diese bevorzugt voneinander beabstandet und durch einen Steg der Kunststoffhalterung voneinander getrennt sind.

Das Leuchtmittel kann einzelne oder eine Kombination der zuvor und/oder nachfolgend in Verbindung mit dem Verfahren beschriebene Merkmale aufweisen, ebenso wie das Verfahren einzelne oder eine Kombination mehrerer zuvor und/oder nachfolgend in Verbindung mit dem Leuchtmittel beschriebene Merkmale aufweisen und/oder verwirklichen kann.

Das Leuchtmittel kann ebenso wie das Verfahren alternativ oder zusätzlich einzelne oder eine Kombination mehrerer einleitend in Verbindung mit dem Stand der Technik und/oder in einem oder mehreren der zum Stand der Technik erwähnten Dokumente und/oder in der nachfolgenden Beschreibung zu den in den Zeichnungen dargestellten Ausführungsbeispielen beschriebene Merkmale aufweisen.

Es ist ersichtlich, dass die Erfindung durch eine mindestens ein Glasplättchen zum Schutz deren organischer Schichten umfassende, kurz als OLED-Plättchen bezeichnete OLED verwirklicht sein kann, die zumindest an ihren Rändern oder einem Teil ihres umlaufenden Rands von einer Kunststoffhalterung umspritzt ist.

Ebenfalls ist ersichtlich, dass die Erfindung durch ein Verfahren zur Herstellung einer zumindest an ihren Rändern oder einem Teil ihres umlaufenden Rands von einer Kunststoffhalterung umspritzten OLED verwirklicht sein kann, bei dem bevorzugt vorgesehen ist, die OLED wenigstens während des Spritzgussvorgangs zu kühlen, um einer Zerstörung ihrer organischen Schichten durch einen Temperaturanstieg vorzubeugen.

Ebenso ist ersichtlich, dass die Erfindung durch eine Fahrzeugleuchte verwirklicht sein kann, bei der mindestens eine zumindest an ihren Rändern oder einem Teil ihres umlaufenden Rands von einer Kunststoffhalterung umspritzte OLED allein oder mit einer oder mehreren weiteren, gleich- oder andersartig ausgeführten Lichtquellen als Lichtquelle zur Erfüllung wenigstens einer Lichtfunktion der Fahrzeugleuchte vorgesehen ist.

Bei der oder den gegebenenfalls vorgesehenen andersartig ausgeführten Lichtquellen kann es sich beispielsweise um Glühlampen und/oder Gasentladungslampen und/oder LEDs handeln.

Eine entsprechend ausgeführte Fahrzeugleuchte umfasst beispielsweise einen im Wesentlichen von einem Leuchtengehäuse und einer Lichtscheibe umschlossenen Leuchteninnenraum und mindestens ein darin beherbergtes, mindestens eine Lichtquelle umfassendes Leuchtmittel für wenigstens eine Lichtfunktion der Fahrzeugleuchte.

Jede Fahrzeugleuchte erfüllt je nach Ausgestaltung eine oder mehrere Aufgaben bzw. Funktionen. Zur Erfüllung jeder Aufgabe bzw. Funktion ist eine Lichtfunktion der Fahrzeugleuchte vorgesehen. Lichtfunktionen sind beispielsweise bei einer Ausgestaltung als Scheinwerfer eine die Fahrbahn ausleuchtende Funktion, oder bei einer Ausgestaltung als Signalleuchte eine Signalfunktion, wie beispielsweise eine Wiederholblinklichtfunktion zur Fahrtrichtungsanzeige oder eine Bremslichtfunktion zur Anzeige einer Bremstätigkeit, oder z.B. einer Begrenzungslichtfunktion, wie etwa einer Rücklichtfunktion, zur Sicherstellung einer Sichtbarkeit des Fahrzeugs bei Tag und/oder Nacht, wie etwa bei einer Ausgestaltung als Heckleuchte oder Tagfahrleuchte. Beispiele für Fahrzeugleuchten sind am Fahrzeugbug, an den Fahrzeugflanken und/oder an den Seitenspiegeln sowie am Fahrzeugheck angeordnete Blinkleuchten, Ausstiegsleuchten, beispielsweise zur Umfeldbeleuchtung, Begrenzungsleuchten, Bremsleuchten, Nebelleuchten, Rückfahrleuchten, sowie typischerweise hoch gesetzte dritte Bremsleuchten, so genannte Central, High-Mounted Braking Lights, Tagfahrleuchten, Scheinwerfer und auch als Abbiege- oder Kurvenlicht verwendete Nebelscheinwerfer, sowie Kombinationen hiervon.

Jede Lichtfunktion muss dabei eine beispielsweise gesetzlich vorgegebene Lichtverteilung erfüllen. Die Lichtverteilung legt dabei mindestens einzuhaltende, umgangssprachlich als Helligkeit bezeichnete Lichtströme in zumindest einzuhaltenden Raumwinkelbereichen fest.

Für die einzelnen Lichtfunktionen sind zum Teil unterschiedliche Helligkeiten bzw. Sichtweiten sowie zum Teil unterschiedliche Lichtfarben zugeordnet.

Wenigstens einer Lichtquelle des Leuchtmittels einer Fahrzeugleuchte können ein oder mehrere zur Ausformung einer Lichtverteilung beitragende Optikelemente zur Lichtlenkung zugeordnet sein.

Die Lichtscheibe ist durch eine heutzutage meist aus einem Kunststoff hergestellte, transparente Abdeckung gebildet, welche den Leuchteninnenraum abschließt und die darin beherbergten Bauteile, wie etwa ein oder mehrere Leuchtmittel, Reflektoren sowie alternativ oder zusätzlich vorgesehene Optikelemente gegen Witterungseinflüsse schützt.

Das Leuchtengehäuse bzw. der Leuchteninnenraum kann in mehrere Kammern mit jeweils eigenen Lichtquellen und/oder Leuchtmitteln und/oder Optikelementen sowie gegebenenfalls Lichtscheiben unterteilt sein, von denen mehrere Kammern gleiche und/oder jede Kammer eine andere Lichtfunktionen erfüllen kann.

Bei den erwähnten Optikelementen kann es sich um wenigstens einen Reflektor und/oder um mindestens eine Linse und/oder um eine oder mehrere im Strahlengang zwischen wenigstens einer Lichtquelle des Leuchtmittels und der Lichtscheibe angeordnete Optikscheiben oder dergleichen handeln.

Beispielsweise kann in dem Leuchteninnenraum mindestens ein hinter wenigstens einer Lichtquelle zumindest eines Leuchtmittels angeordneter Reflektor untergebracht sein. Der Reflektor kann zumindest zum Teil durch ein separates Bauteil und/oder durch wenigstens einen Teil des Leuchtengehäuses selbst gebildet sein, beispielsweise vermittels einer zumindest teilweisen, reflektierenden Beschichtung.

Die Lichtscheibe selbst kann alternativ oder zusätzlich als ein Optikelement ausgebildet sein, beispielsweise indem sie vorzugsweise an deren Innenseite mit einer zur Erzeugung einer oder mehrerer zuvor erwähnter Lichtverteilungen beitragenden optischen Struktur versehen ist. Hierdurch kann gegebenenfalls auf eine Optikscheibe verzichtet werden.

Beispiele für Fahrzeugleuchten sind am Fahrzeugbug, an den Fahrzeugflanken und/oder an den Seitenspiegeln sowie am Fahrzeugheck angeordnete Wiederholblinkleuchten, Ausstiegsleuchten, beispielsweise zur Umfeldbeleuchtung, Begrenzungsleuchten, Bremsleuchten, Nebelleuchten, Rückfahrleuchten, sowie typischerweise hoch gesetzte dritte Bremsleuchten, so genannte Central, High-Mounted Braking Lights, Tagfahrleuchten, Scheinwerfer und auch als Abbiege- oder Kurvenlicht verwendete Nebelscheinwerfer, sowie Kombinationen hiervon.

Eine solche Kombination ist beispielsweise regelmäßig in den bekannten Heckleuchten verwirklicht. In diesen kommen beispielsweise Wiederholblinkleuchten, Begrenzungsleuchten, Bremsleuchten, Nebelleuchten sowie Rückfahrleuchten zum Einsatz, um nur eine von vielen in Heckleuchten verwirklichten Kombinationen zu nennen. Weder erhebt diese Aufzählung Anspruch auf Vollständigkeit, noch bedeutet dies, dass in einer Heckleuchte alle genannten Leuchten kombiniert werden müssen. So können beispielsweise auch nur zwei oder drei der genannten oder auch anderer Leuchten in einem gemeinsamen Leuchtengehäuse einer Heckleuchte miteinander kombiniert sein.

Zusätzliche, über die Lösung der gestellten Aufgabe und/oder über die voran zu den einzelnen Merkmalen genannten Vorteile hinausgehende Vorteile gegenüber dem Stand der Technik sind nachfolgend aufgeführt.

Vorteilhaft gegenüber dem Stand der Technik ist, dass die um mindestens ein OLED-Plättchen umspritzte oder umgossene Kunststoffhalterung unabhängig vom OLED Aufbau ist. Die OLEDs können aus Glas-Glas-Flächen an der Außenseite bestehen oder Glas-Aluminium oder Glas-Glas-Aluminium. Da die OLEDs überwiegend und bevorzugt nur am Rand gefasst werden, ist das unerheblich. Es muss also nicht für jedes Außenflächenmaterial der OLED ein geeigneter Kleber oder Klebeband gesucht werden, das alle Anforderungen für die stabile Halterung erfüllt. Vielmehr stellt die Erfindung eine universelle Lösung für viele Kombinationen, auch solche mit Glasplättchen und/oder Kunststoffplättchen dar.

Weitere Vorteile ergeben sich durch eine Ressourceneinsparung, beispielsweise eine Einsparung bislang erforderlicher, zeit- und/oder kostenaufwändiger Befestigungsmethoden von OLED-Plättchen an Trägern.

Zusätzliche Vorteile ergeben sich durch geringe Herstellungskosten, eine hohe Betriebszuverlässigkeit sowie die dauerhafte Erfüllung fahrzeugspezifischer Anforderungen.

Ferner bietet die Erfindung einen wirkungsvollen Schutz vor Beschädigung aus Glas oder transparentem Kunststoff bestehender Deckschichten von OLED-Plättchen bei der Montage und im Betrieb einer Fahrzeugleuchte. Diesem Schutz trägt die das OLED-Plättchen zumindest bereichsweise umgebende Fassung der durch Umgießen oder Umspritzen des OLED-Plättchen hergestellten Kunststoffhalterung bei. Die spritzgusstechnisch hergestellte Fassung verhindert hierbei die Übertragung von den Deckschichten aus Glas gefährlich werdenden Biegemomenten auf die OLED durch das beim Stand der Technik erforderliche Einbringen und/oder Befestigen des OLED-Plättchens an und/oder auf einem Träger, da sie aufgrund ihrer umgießungs- oder spritzgusstechnischen Herstellung das OLED-Plättchen keinen Biegemomenten aussetzt.

Die Erfindung bietet damit einen hohen Schutz der OLED vor Beschädigung oder Zerstörung beim Umgang mit dem Leuchtmittel insbesondere während der Montage und während des Betriebs einer Fahrzeugleuchte sowie eine hohe Haltbarkeit, einen hohen Qualitätseindruck und geringe Herstellungskosten.

Vorteile gegenüber dem Stand der Technik sind außerdem die Erzielung einerseits einer größtmöglichen optischen Güte einhergehend mit einer bestmöglichen Ausnutzung des von einer OLED emittierten Lichts unter Erhalt eines größtmöglichen Beitrags zu einer Lichtverteilung mindestens einer Lichtfunktion insbesondere einer Fahrzeugleuchte, und andererseits die Sicherstellung eines notwendigen Waltens von Sorgfalt beim Umgang mit OLEDs insbesondere bei deren Verwendung in Fahrzeugleuchten.

Darüber hinaus gehende Vorteile sind außerdem eine erzielbare kompakte Bauform des Leuchtmittels.

Die Erfindung wird nachfolgend anhand von in der Zeichnung dargestellter Ausführungsbeispiele näher erläutert. Die Größenverhältnisse der einzelnen Elemente zueinander in den Figuren entsprechen nicht immer den realen Größenverhältnissen, da einige Formen vereinfacht und andere Formen zur besseren Veranschaulichung vergrößert im Verhältnis zu anderen Elementen dargestellt sind. Für gleiche oder gleich wirkende Elemente der Erfindung werden identische Bezugszeichen verwendet. Ferner werden der Übersicht halber nur Bezugszeichen in den einzelnen Figuren dargestellt, die für die Beschreibung der jeweiligen Figur erforderlich sind. Die dargestellten Ausführungsformen stellen lediglich Beispiele dar, wie die Erfindung ausgestaltet sein kann und stellen keine abschließende Begrenzung dar. Es zeigen in schematischer Darstellung:
- Fig. 1: ein erstes Ausführungsbeispiel eines Leuchtmittels in einer perspektivischen Ansicht auf die zur Lichtabstrahlung vorgesehene Vorderseite des OLED-Plättchens.
- Fig. 2: das Leuchtmittel aus Fig. 1 in einer perspektivischen Ansicht auf die Rückseite des OLED-Plättchens.
- Fig. 3: das Leuchtmittel aus Fig. 1 in einer Draufsicht auf die zur Lichtabstrahlung vorgesehene Vorderseite des OLED-Plättchens.
- Fig. 4: das Leuchtmittel aus Fig. 1 in einer Draufsicht auf die Rückseite des OLED-Plättchens.
- Fig. 5: ein zweites Ausführungsbeispiel eines Leuchtmittels in einer perspektivischen Ansicht auf die zur Lichtabstrahlung vorgesehene Vorderseite des OLED-Plättchens.
- Fig. 6: das Leuchtmittel aus Fig. 5 in einer perspektivischen Ansicht auf die Rückseite des OLED-Plättchens.
- Fig. 7: ein drittes Ausführungsbeispiel eines Leuchtmittels in Fig. 7 a) in einer Seitenansicht und in Fig. 7 b) in einem Querschnitt.
- Fig. 8: ein viertes Ausführungsbeispiel eines Leuchtmittels in Fig. 8 a) in einer Draufsicht auf die zur Lichtabstrahlung vorgesehene Vorderseite des OLED-Plättchens und in Fig. 8 b) in einem Querschnitt entlang der Linie A-A aus Fig. 8 a).
- Fig. 9: ein weiteres Ausführungsbeispiel eines Leuchtmittels in perspektivischer Ansicht, unter Darstellung von an einer Kunststoffhalterung aus transparentem Material, mit welcher das OLED-Plättchen zumindest an seinen Rändern oder einem Teil seines umlaufenden Rands umspritzt und/oder umgossen ist, angeordneten Auskopeloptiken.
- Fig. 10: eine vergrößerte Ansicht der Auskoppeloptiken des Leuchtmittels aus Fig. 9.
- Fig. 11: ein zusätzliches Ausführungsbeispiel eines Leuchtmittels in perspektivischer Ansicht, unter Darstellung von an einer Kunststoffhalterung aus transparentem Material, mit welcher das OLED-Plättchen zumindest an seinen Rändern oder einem Teil seines umlaufenden Rands umspritzt und/oder umgossen ist, angeordneten Auskopeloptiken.
- Fig. 12: eine erste vergrößerte perspektivische Ansicht der Auskoppeloptiken des Leuchtmittels aus Fig. 11.
- Fig. 13: eine zweite vergrößerte perspektivische Ansicht der Auskoppeloptiken des Leuchtmittels aus Fig. 11.
- Fig. 14: eine dritte vergrößerte perspektivische Ansicht der Auskoppeloptiken des Leuchtmittels aus Fig. 11.
- Fig. 15: ein letztes Ausführungsbeispiel eines Leuchtmittels in perspektivischer Ansicht, unter Darstellung von an einer Kunststoffhalterung aus transparentem Material, mit welcher das OLED-Plättchen zumindest an seinen Rändern oder einem Teil seines umlaufenden Rands umspritzt und/oder umgossen ist, angeordneten Auskopeloptiken.
- Fig. 16: eine erste vergrößerte perspektivische Ansicht der Auskoppeloptiken des Leuchtmittels aus Fig. 15.
- Fig. 17: eine zweite vergrößerte perspektivische Ansicht der Auskoppeloptiken des Leuchtmittels aus Fig. 15.
- Fig. 18: sein Detail eines Verfahrens zur Herstellung eines Leuchtmittels in einem Querschnitt durch das Leuchtmittel und eines zur Ausführung des Details des Verfahrens vorgesehenen Teils einer Vorrichtung zur Durchführung des Verfahrens.

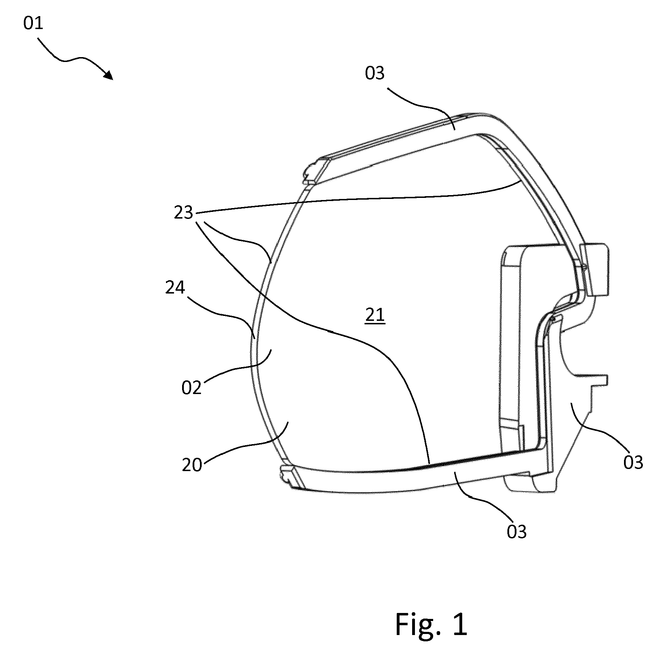

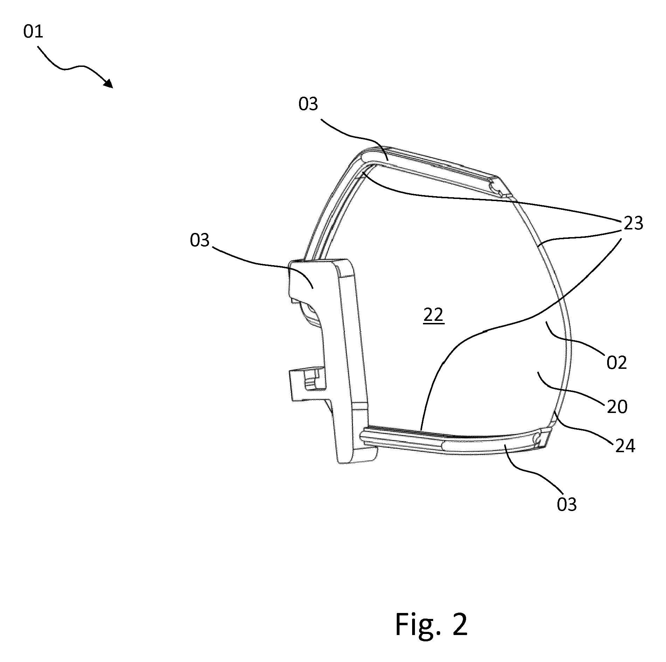

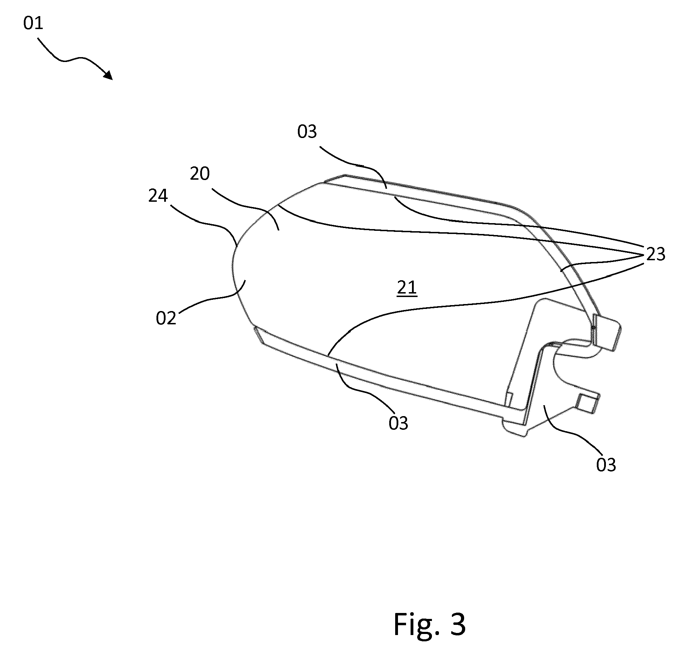

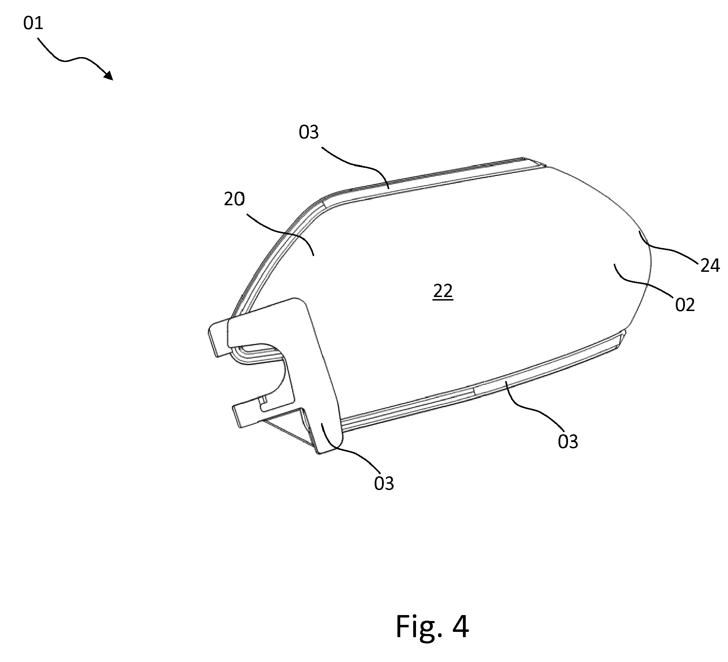

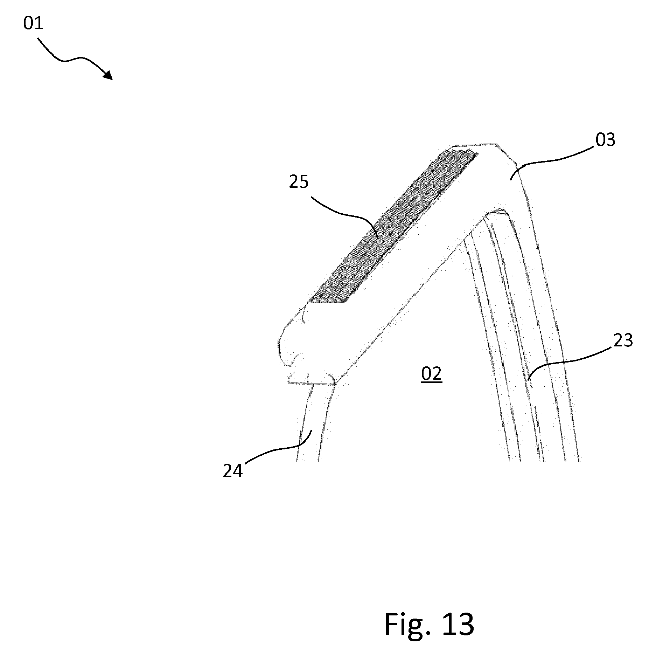

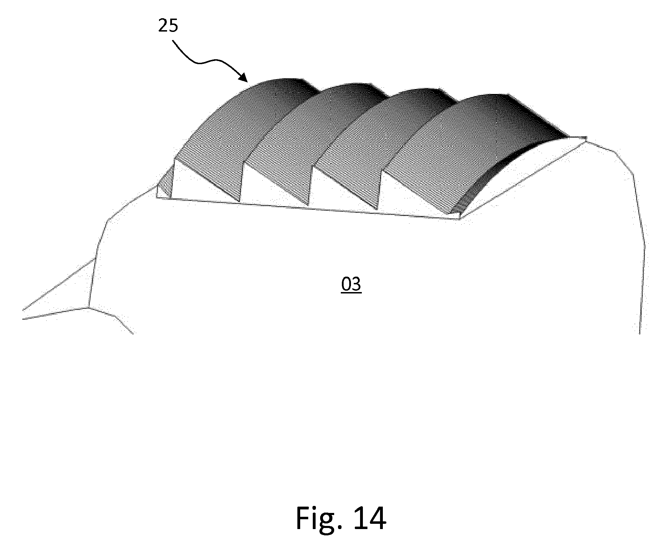

Ein in Fig. 1 bis Fig. 17 ganz oder in Teilen dargestelltes Leuchtmittel 01 umfasst mindestens eine OLED 20 als Lichtquelle.

Die OLED 20 besteht aus wenigstens einem Stapel umfassend organisch halbleitende Materialien mit mindestens einer zwischen elektrisch leitenden, beispielsweise metallischen Schichten für Anode und Kathode eingeschlossen Emitterschicht. Die OLED 20 ist Teil eines OLED-Plättchens 02, bei dem der wenigstens eine Stapel zum Schutz gegen Wasser, Sauerstoff sowie zum Schutz gegen andere Umwelteinflüsse, wie etwa Kratzbeschädigung und/oder Druckbelastung zumindest vorder- und rückseitig beispielsweise mit einem anorganischen Material, insbesondere mit Glas verkapselt ist. Das OLED-Plättchen 02 weist eine beispielsweise durch ein Glasplättchen gebildete Vorderseite 21, eine beispielsweise ebenfalls durch ein Glasplättchen oder durch eine Metallschicht gebildete Rückseite 22 sowie einen dessen Vorderseite 21 und Rückseite 22 verbindenden, umlaufenden Rand 23 auf.

Der umlaufende Rand 23 des OLED-Plättchens 02 erstreckt sich hierbei zumindest zwischen den beiden jeweils die Vorderseite 21 und die Rückseite 22 des OLED-Plättchens 02 begrenzenden, umlaufenden Kanten des OLED-Plättchens 02.

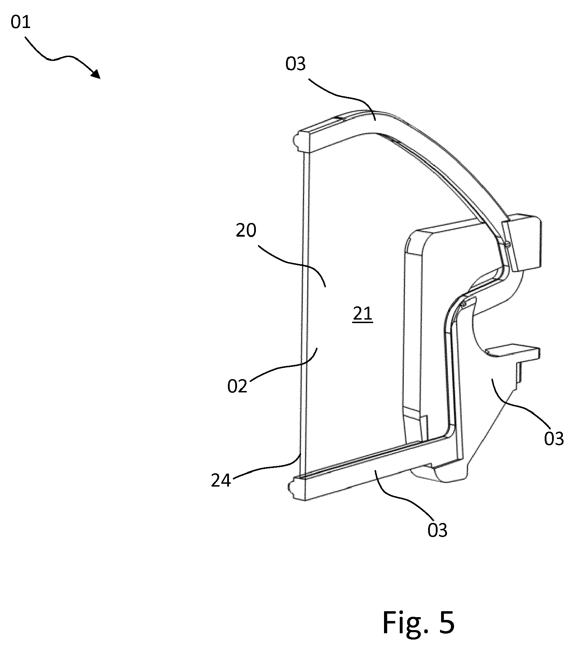

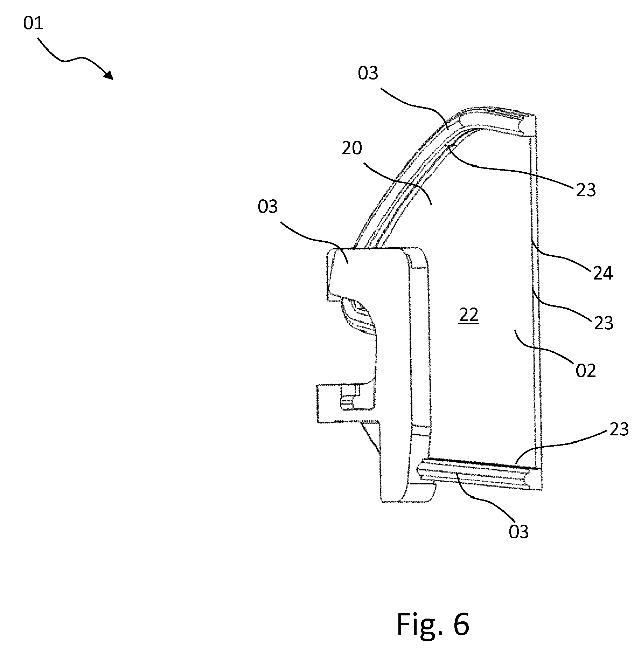

Der Rand 23 kann zumindest abschnittsweise in einem Bogen konkav oder wie in Fig. 1 bis 4, Fig. 9, Fig. 11 und Fig. 15 dargestellt konvex geschwungen, oder wie in Fig. 5 und Fig. 6 dargestellt zumindest abschnittsweise gerade verlaufen. Auch Kombinationen des abschnittsweisen Verlaufs des Rands 23 sind möglich, ebenso wie eine Ausführung des Rands 23 als Freiformgeometrie.

Das OLED-Plättchen 02 ist zumindest an seinen Rändern oder einem Teil seines umlaufenden Rands 23 von einer Kunststoffhalterung 03 umspritzt und/oder umgossen.

Die Kunststoffhalterung 03 bildet damit eine zumindest an einem Teil des umlaufenden Rands 23 des OLED-Plättchens 02 dieses umgebende Kunststoffumrandung. Die Kunststoffumrandung umgibt den Rand 23 des OLED-Plättchens 02 zumindest abschnittsweise entlang derjenigen Partien des umlaufenden Rands 23, in denen das OLED-Plättchen 02 von der Kunststoffhalterung 03 umspritzt und/oder umgossen ist.

Die Kunststoffhalterung 03 besteht zumindest im Bereich der Ränder 23 aus einem zumindest für von dem OLED-Plättchen innerhalb des für das menschliche Auge sichtbaren Teils des elektromagnetischen Spektrums abgestrahltes Licht transparenten Kunststoff.

Das OLED-Plättchen ist zumindest an seinen Rändern 23 oder einem Teil seines umlaufenden Rands 23 von der Kunststoffhalterung 03 aus zumindest in diesem Bereich mindestens im für das menschliche Auge sichtbaren Teil des elektromagnetischen Spektrums transparentem Material umspritzt und/oder umgossen.

An der das OLED-Plättchen 02 zumindest an einem Teil seines umlaufenden Rands 23 umgebenden Kunststoffhalterung 03 ist mindestens eine an den von der Kunststoffhalterung 03 umgebenen Kanten des OLED-Plättchens 02 austretendes Licht in eine vorgegebene oder erwünschte Richtung umlenkende Auskoppeloptik 25 angeordnet.

Die Kunststoffhalterung 03 kann durch Hinterspritzung einer Folie hergestellt sein, welche Folie mit einer eine Auskoppeloptik 25 bildenden, vorgefertigten, beispielsweise durch Drucken und/oder Stanzen und/oder Tiefziehen hergestellten Struktur versehen sein kann.

Alternativ oder zusätzlich kann die Auskoppeloptik 25 vermittels Laserstrukturierung der Kunststoffhalterung 03 hergestellt sein.

In einer Draufsicht normal zur Vorderseite 21 und Rückseite 22 des OLED-Plättchens 02 gesehen ist dieses nicht zwingend allseitig an seinem gesamten umlaufenden Rand 23 von der Kunststoffhalterung 03 umspritzt und/oder umgossen. In denjenigen Partien des umlaufenden Rands 23, in denen das OLED-Plättchen 02 von der Kunststoffhalterung 03 umspritzt und/oder umgossen ist, umgibt die Kunststoffhalterung 03 in einem normal zur Vorderseite 21 und Rückseite 22 des OLED-Plättchens 02 verlaufenden Querschnitt den Rand 23 vollständig und kann zugleich Teile der Vorderseite 21 und/oder Rückseite 22 des OLED-Plättchens 02 bedecken.

Zur vorder- und/oder rückseitigen Verkapselung dienen vorzugsweise Glasplättchen. Demnach bildet vorzugsweise ein Glasplättchen die Vorderseite 21 und/oder die Rückseite 22.

Eine der rückseitigen Verkapselung dienende Schicht kann beispielsweise aus einem Metall oder einer Metalllegierung hergestellt sein oder bestehen.

Alternativ oder zusätzlich können zur vorder- und/oder rückseitigen Verkapselung dienende Schichten und/oder Plättchen, beispielsweise Glasplättchen an ihrer den organischen Schichten im Inneren der OLED 20 abgewandten Außenseite andere Materialien aufweisen, wie etwa Aluminium zur Wärmeleitung und -spreitzung.

Das OLED-Plättchen kann in einer Draufsicht normal zur Vorderseite 21 und Rückseite 22 des OLED-Plättchens 02 gesehen:
- von zwei Seiten her L-förmig, oder
- von zwei gegenüberliegenden Seiten her entsprechend einer gabelförmigen Umspritzung oder Umgießung, bei der das OLED-Plättchen 02 zwischen zwei Zinken einer gabelförmigen Kunststoffhalterung 03 angeordnet ist, oder
- von drei Seiten her C-förmig, oder
- allseitig um dessen gesamten, umlaufenden Rand 23 herum von der Kunststoffhalterung 03 umspritzt und/oder umgossen sein.

Das OLED-Plättchen 02 kann vorder- oder rückseitig ganz oder teilweise von der Kunststoffhalterung 03 umspritzt und/oder umgossen sein.

Beispielsweise kann das OLED-Plättchen 02 zusätzlich vollflächig an deren Rückseite 22 umspritzt und/oder umgossen sein.

Sofern die Kunststoffhalterung 03 vollständig aus einem zumindest im für das menschliche Auge sichtbaren Teil des elektromagnetischen Spektrums transparenten Kunststoff hergestellt ist, kann auch eine einer Lichtabgabe dienende oder zur Lichtabgabe vorgesehene Vorderseite 21 und/oder Rückseite 22 des OLED-Plättchens 02 jeweils ganz oder teilweise von einer zumindest an der entsprechenden, zur Lichtabgabe vorgesehenen Vorderseite 21 und/oder Rückseite 22 aus transparentem Kunststoff hergestellten Kunststoffhalterung 03 umspritzt und/oder umgossen sein.

Soll dabei auf der Vorderseite 21 des OLED-Plättchens 02 Licht abgestrahlt werden, wohingegen auf der Rückseite 22 eine Lichtabstrahlung nicht erforderlich und/oder gar unerwünscht ist, so kann das OLED-Plättchen 02 rückseitig ganz oder teilweise von opakem Material der Kunststoffhalterung 03 umspritzt und/oder umgossen sein, wohingegen das OLED-Plättchen 02 auf seiner Vorderseite 21 entweder frei von der Kunststoffhalterung 03 ausgeführt ist oder ebenso wie an seinen von der Kunststoffhalterung 03 umspritzten und/oder umgebenen Rändern 23 nur von einer Kunststoffhalterung 03 aus einem zumindest im für das menschliche Auge sichtbaren Teil des elektromagnetischen Spektrums transparenten Kunststoff ganz oder teilweise umspritzt und/oder umgossen sein darf. Hierbei ist hervorzuheben, dass eine Kombination aus opakem Kunststoff auf der Rückseite 22 und transparentem Kunststoff an den Rändern 23 und auf der Vorderseite 21 durch Umspritzung oder Umgießung in einem mehrstufigen Spritzgussprozess denkbar ist.

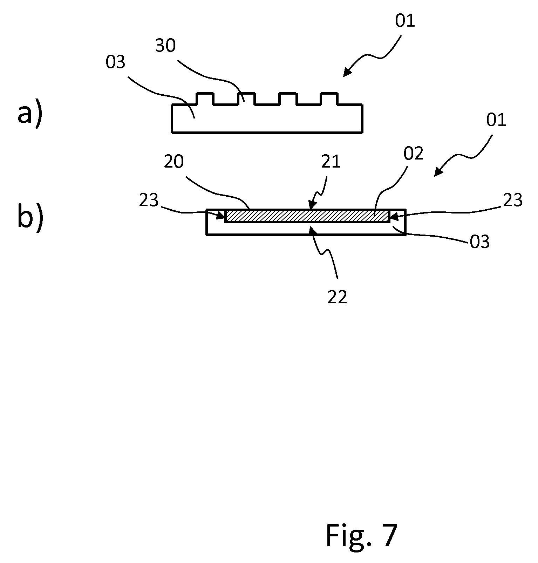

Zur besseren Füllung der Kunststoffhalterung 03 während des Umspritzens und/oder Umgießens des OLED-Plättchens 02 mit Kunststoff-Material können Fließhilfen 30 (Fig. 7 a)) in Form von beispielsweise Rippen an der Kunststoffhalterung 03 vorgesehen sein. Die Fließhilfen 30 können zusätzlich einer Steifigkeitserhöhung des fertigen Leuchtmittels 01 dienen.

Die Kunststoffhalterung 03 kann als ein in MID-Technik hergestellter Leiterbahnträger ausgeführt sein, zumindest ein Teil dessen Leiterbahnen mit elektrischen Anschlüssen der OLED 20 des mindestens einen OLED-Plättchens 02 elektrisch verbunden und/oder elektrisch verbindbar sind. Damit erfüllt die Kunststoffhalterung 03 gleichzeitig mehrere Funktionen, erstens die spannungs- und momentenfreie Halterung des mindestens einen OLED-Plättchens 02, zweitens die elektrische Kontaktierung der OLED 20 des OLED-Plättchens 02 und drittens die elektrische Weiterverbindung der OLED 20 des OLED-Plättchens 02 mit einer auf dem spritzgegossenen Schaltungsträger angeordneten, durch mindestens ein mit den Leiterbahnen des in MID-Technik hergestellten Leiterbahnträgers verbundenes oder verbindbares Elektronikbauteil gebildeten elektronischen Steuerschaltung.

Die in MID-Technik hergestellte Kunststoffhalterung 03 bildet so einen Schaltungsträger, mit dessen Leiterbahnen zusätzlich zu der mindestens einen OLED 20 ein oder mehrere weitere Elektronikbauteile elektrisch kontaktiert und mechanisch an dem Schaltungsträger befestigt sein können.

Dies hat den besonderen Vorteil, dass zum Betrieb von OLEDs 20 als Lichtquellen für ein Leuchtmittel 01 beispielsweise einer Fahrzeugleuchte eine oder mehrere mehr oder minder komplexe elektronische Steuerschaltungen vorgesehen sein können, die aus einem oder mehreren Elektronikbauteilen aufgebaut sein können.

Ein einfaches Beispiel für eine elektronische Steuerschaltung betrifft die Angleichung unterschiedlicher Helligkeiten einzelner OLEDs 20 oder von OLED-Strängen innerhalb einer Gruppe gemeinsam betriebener OLEDs 20. Eine solche elektronische Steuerschaltung besteht aus mindestens einem oder mehreren Vorwiderständen zur Anpassung der Vorwärtsspannung der OLEDs 20 an das Bordnetz. Beispielsweise ist denkbar, die OLEDs 20 nach Vorwärtsspannung und Intensität zu sortieren. Um Unterschiede zwischen mehreren OLED-Strängen auszugleichen, die jeweils aus in Reihe geschalteten OLEDs 20 gleicher Vorwärtsspannung und Intensität bestehen, und um eine homogene Helligkeitsverteilung der benachbarten OLED-Stränge aus OLEDs 20 mit unterschiedlicher Vorwärtsspannung und Intensität zu erhalten, wird zumindest jeder OLED-Strang mit einem anderen Vorwiderstand versehen.

OLDEs 20 bedürfen darüber hinaus beim Einsatz als Lichtquelle insbesondere in Fahrzeugleuchten oft einer separaten Ausfallerkennung. Dies ist bedingt durch die geringe Leistungsaufnahme von OLEDs 20 im Allgemeinen. Beispielsweise ist ein in einem Fahrzeug untergebrachtes Steuergerät nicht in der Lage, eine dem Ausfall einer oder weniger OLEDs 20 entsprechende Änderung der Leistungsentnahme aus dem Bordnetz zu erkennen, da eine hieraus resultierende Bordnetzspannungsänderung unterhalb der im normalen Betrieb eines Fahrzeugs auftretenden Bordnetzspannungssschwankungen liegt. Eine beispielsweise in der Fahrzeugleuchte untergebrachte elektronische Schaltungsanordnung zur Ausfallerkennung erfasst den Ausfall einer oder mehrerer OLEDs 20 in der Fahrzeugleuchte beispielsweise mittels eines oder mehrerer Komparatoren und teilt dies dem Steuergerät mit. Diese elektronische Schaltungsanordnung zur Ausfallerkennung kann durch eine beispielsweise auf dem Leuchtmittelträger aufgebrachte elektronische Steuerschaltung verwirklicht sein.

Darüber hinaus können OLEDs 20 weiterer elektronischer Steuerschaltungen bedürfen. Beispiele hierfür sind elektronische Steuerschaltungen:
- zur Regelung und/oder Steuerung der Helligkeit bzw. Leuchtkraft OLEDs 20, beispielsweise durch eine pulsweitenmodulierte Taktung der Stromversorgung für einen außerhalb des für das menschliche Auge wahrnehmbaren Bereichs gepulsten Betrieb,
- zur Kompensation oder Vermeidung elektromagnetischer Störungen, beispielsweise aufgebaut aus Kondensatoren und/oder Ferriten,
- zum Schutz der OLEDs 20 beispielsweise vor einer Überspannung des Bordnetzes oder vor fehlerhafter Polung, beispielsweise umfassend eine oder mehrere Zenerdioden,

Zusammengefasst kann für fast alle OLED-Anwendungen eine mehr oder minder umfangreiche, für die speziellen OLEDs 20 ausgelegte elektronische Steuerschaltung vorgesehen sein. Die elektronische Steuerschaltung umfasst im einfachsten Fall einen Vorwiderstand und gegebenenfalls zusätzlich eine Schutzdiode, kann aber je nach Anwendung auch wesentlich mehr Elektronikbauteile enthalten, wie z.B. Mikrokontroller bzw. Kontroller, Komparatoren, Transistoren, Schutzdioden, elektrische Widerstände beispielsweise als Vorwiderstand, Kondensatoren, Ferrite, DC/DC-Wandlerschaltungen, etc..

Somit kann ein Leuchtmittel 01 mit einer oder mehreren OLEDs 02 als Lichtquelle meist zusätzlich zu einer oder mehreren aufgrund ihres Diodenaufbaus Elektronikbauteile darstellenden OLEDs 20 zumindest ein weiteres zuvor genanntes Elektronikbauteil umfassen. Demnach kann ein Leuchtmittel 01 mit einer oder mehreren OLEDs 20 als Lichtquellen neben der mindestens einen OLED 20 zumindest noch über ein weiteres Elektronikbauteil verfügen.

Dank der Ausgestaltung der Kunststoffhalterung 03 als ein in MID-Technik ausgeführter, spritzgegossener Schaltungsträger kann ein besonders kompakt gebautes Leuchtmittel 01 erhalten werden, das bereits eine oder mehrere zum Betrieb einer oder mehrerer OLEDs 20 als Lichtquellen erforderliche elektronische Steuerschaltungen oder Teile hiervon umfasst.

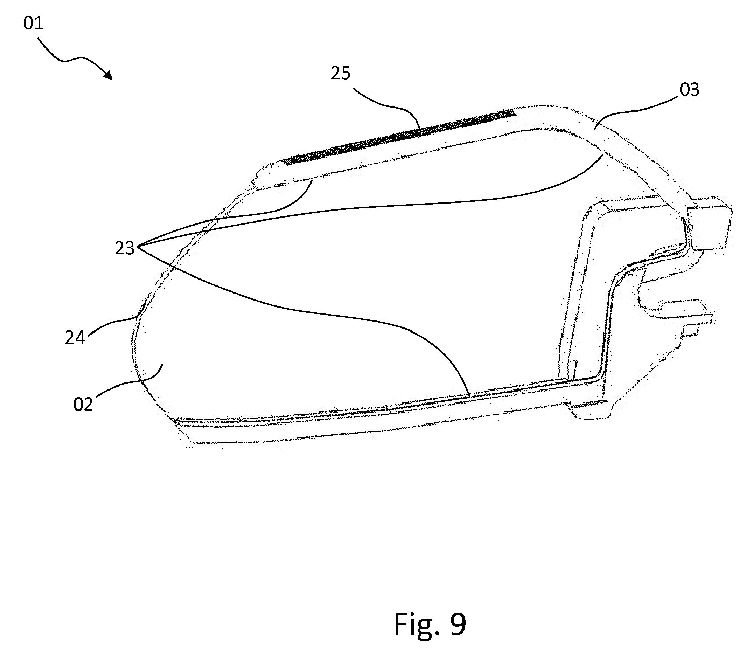

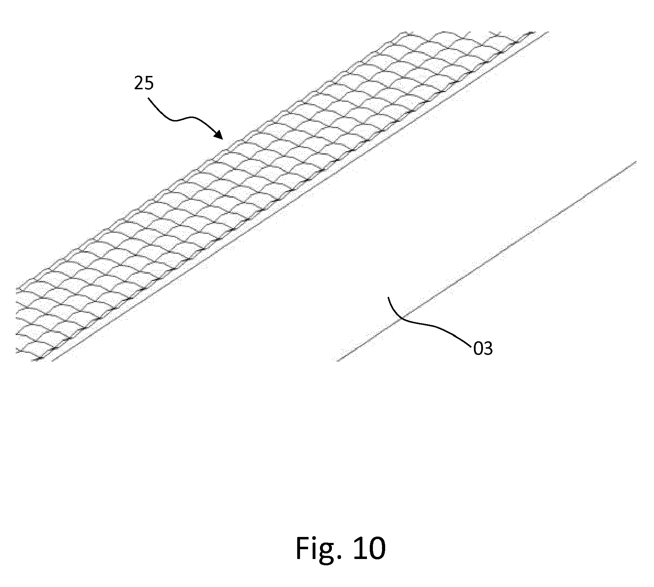

Fig. 9 zeigt ein Ausführungsbeispiel eines Leuchtmittels 01 mit einem von einer Kunststoffhalterung 03 umspritzten OLED-Plättchen 02, bei dem auf dem den Rand 23 des OLED-Plättchens 02 umgebenden, transparenten Teil der Kunststoffhalterung 03 optisch wirksame Oberflächen als Auskoppeloptik 25 angeformt sind, die zur Lichtlenkung und/oder -steuerung dienen. Hierbei sind die optisch wirksamen Oberflächen der Auskoppeloptik 25 als beispielsweise sphärische, asphärische oder als Freiform-Oberflächen gestaltete Kissen ausgebildet. Fig. 10 zeigt dies in einer vergrößerten perspektivischen Ansicht.

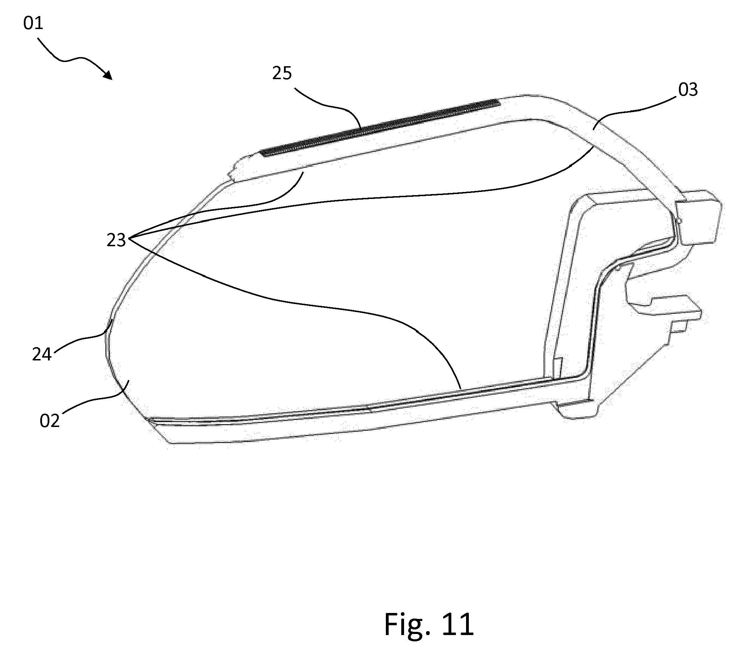

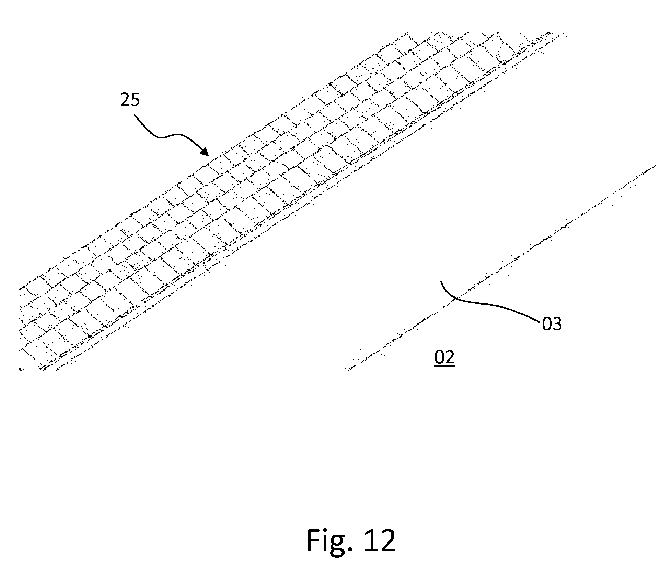

Fig. 11 zeigt ein weiteres Ausführungsbeispiel eines Leuchtmittels 01 mit einem von einer Kunststoffhalterung 03 umspritzten OLED-Plättchen 02 bei dem auf dem den Rand 23 des OLED-Plättchens 02 umgebenden, transparenten Teil der Kunststoffhalterung 03 optisch wirksame Oberflächen als Auskoppeloptik 25 angeformt sind, die zur Lichtlenkung und/oder -steuerung dienen. Hierbei sind die optisch wirksamen Oberflächen der Auskoppeloptik 25 als plane, sphärische, asphärische oder als Freiform-Oberflächen gestaltete Prismen ausgebildet. Fig. 12, Fig. 13 und Fig. 14 zeigen dies in einer vergrößerten perspektivischen Ansicht.

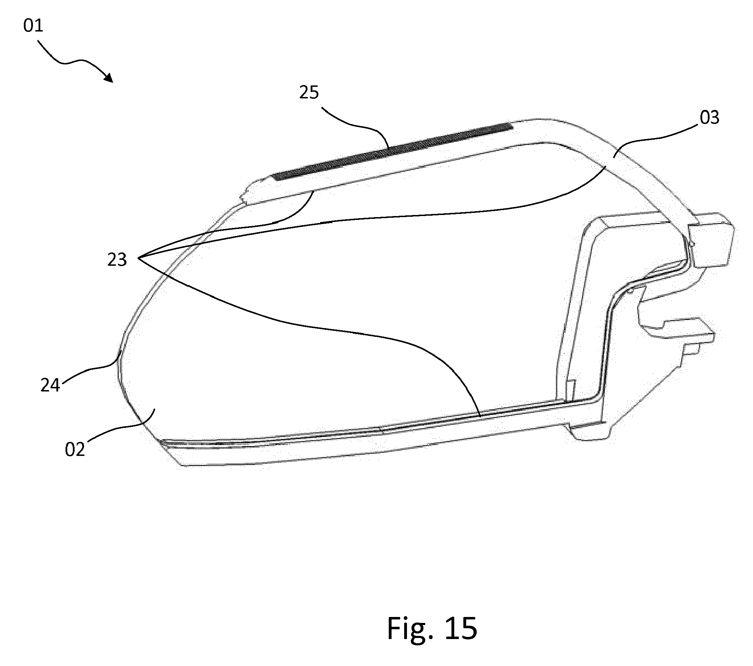

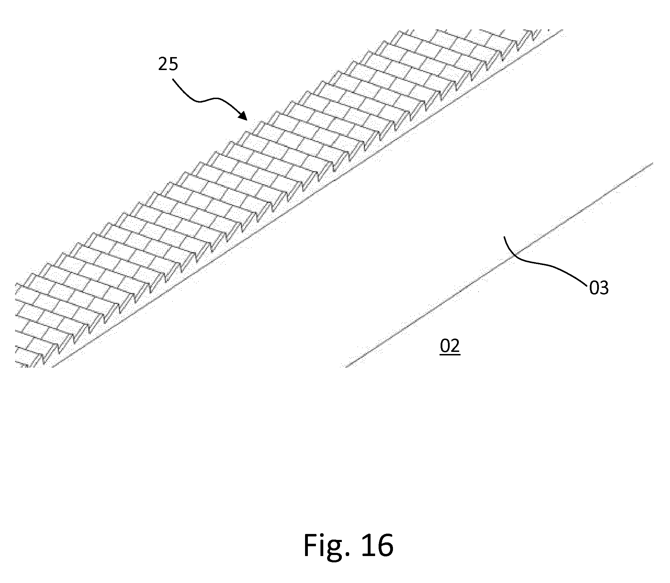

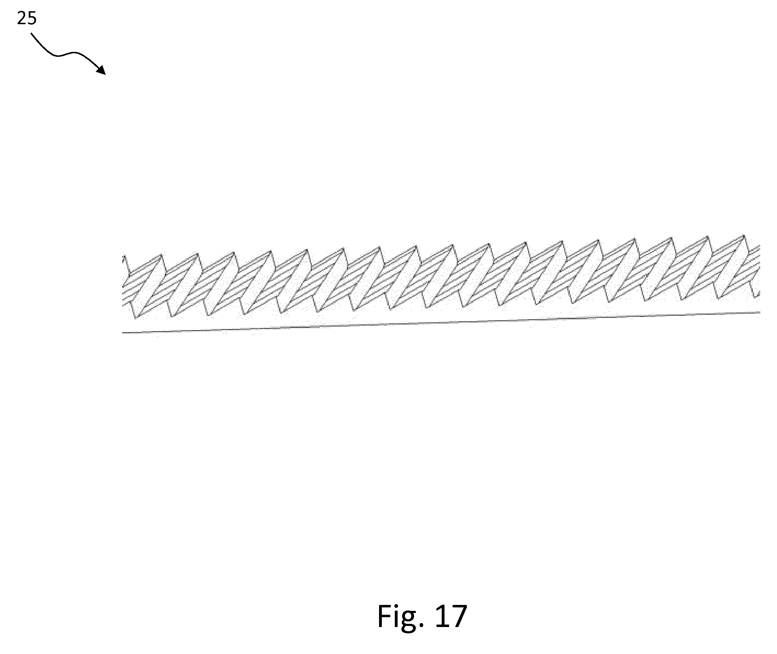

Fig. 15 zeigt ein zusätzliches Ausführungsbeispiel eines Leuchtmittels 01 mit einem von einer Kunststoffhalterung 03 umspritzten OLED-Plättchen 02 bei dem auf dem den Rand 23 des OLED-Plättchens 02 umgebenden, transparenten Teil der Kunststoffhalterung 03 optisch wirksame Oberflächen als Auskoppeloptik 25 angeformt sind, die zur Lichtlenkung und/oder -steuerung dienen. Hierbei sind die optisch wirksamen Oberflächen der Auskoppeloptik 25 bildenden, beispielsweise als plane, sphärische, asphärische oder als Freiform-Oberflächen gestalteten Prismenoberflächen im Vergleich zur in Fig. 11, Fig. 12, Fig. 13, Fig. 14 gezeigten Ausgestaltung anders ausgerichtet. Fig. 16 und Fig. 17 zeigen dies in einer vergrößerten perspektivischen Ansicht.

Als optisch wirksame Oberflächen der Auskoppeloptik 25 kommen alternativ oder zusätzlich auch Mikrooptiken in Frage.

Eine gezielte Lichtsteuerung und/oder -lenkung durch Auskoppeloptiken 25 im Bereich des von der Kunststoffhalterung 03 umgriffenen Rands 23 des OLED-Plättchens 02 kann insbesondere dann sinnvoll sein, wenn beispielsweise in bestimmte Raumwinkelbereiche überhaupt kein Licht abgegeben werden darf, wie etwa der Vermeidung einer Abstrahlung roten Lichts nach vorne in Fahrtrichtung von am Straßenverkehr teilnehmenden Fahrzeugen. Solches Licht, das ohne zusätzliche Maßnahmen an den Kanten eines OLED-Plättchens 02 in einen regelungstechnisch und/oder gesetzlich verbotenen Bereich abstrahlt, wird mit Hilfe der Auskoppeloptik 25 an der den Randbereich des OLED-Plättchens umgebenden Kunststoffhalterung 03 entsprechend in andere Bereiche gelenkt und/oder gestreut und/oder gebrochen und/oder auf andere Art und Weise abgelenkt und/oder gesteuert.

Wichtig ist hervorzuheben, dass als Auskoppeloptik 25 grundsätzlich auch an entsprechender Stelle auf der Oberfläche der Kunststoffhalterung 03 beispielsweise aufgedruckte und/oder laminierte Punktmuster und/oder andere aufgebrachte Streu- und/oder Lichtlenkelemente denkbar sind. Auch können die Muster auf einer Folie aufgebracht sein, die wiederum zusammen mit der OLED hinterspritzt werden kann.

Auch können solche Punkte oder andere Geometrien mit Hilfe eines Lasers auf die Oberfläche oder sogar in das transparente Material oder ein dahinter liegendes opakes Material der Kunststoffhalterung 03 selbst eingebracht werden, wobei sie nicht an der Oberfläche auf- oder eingebracht, sondern innerhalb des Volumens des Körpers der Kunststoffhalterung 03 eingebracht werden. Bei dem letztgenannten Verfahren werden durch die Laserenergie in dem transparenten Material lokal die Materialeigenschaften geändert, wodurch Streuvolumenbereiche erzeugt werden, die zur Lichtlenkung berechnet und verwendet werden können.

Alternativ zu einer Vermeidung einer Lichtabstrahlung in einem verbotenen Raumwinkelbereich kann die Lichtsteuerung und/oder -lenkung vermittels der Auskoppeloptik 25 eingesetzt werden, um im Bereich des mit einer Auskoppeloptik 25 versehenen Teils der Kunststoffhalterung 03 am darunter liegenden Rand des OLED-Plättchens 02 austretendes Licht einer seitlichen Lichtverteilung zuzuführen, beispielsweise zur gleichzeitigen Erfüllung einer Seitenmarkierungslichtfunktion mittels eines zur Erfüllung einer Schlusslichtfunktion vorgesehenen OLED-Plättchens 02.

Da die OLED-Halterung in einer Leuchte für die OLED ohnehin benötigt wird, ergeben sich mit dieser Erfindung keine zusätzlichen Kosten. Daher ist dieser Ansatz kostengünstiger als zusätzliche Linsen und/oder Reflektoren für die OLED vorzusehen und/oder zusätzliche Lichtquellen mit entsprechenden optischen Systemen vorzuhalten, um beispielsweise eine Seitenmarkierungslichtfunktion-Funktion zu verwirklichen.

Weiterhin kann die Erfindung eingesetzt werden, wenn aufgrund von etwa durch einen Strakverlauf vorgegebene Geometrie- und/oder Gestaltungsvorgaben in der Leuchte einzelne Winkelbereiche für Leuchtenfunktionen schwer oder nicht zu erreichen sind, ohne zusätzliche optische Elemente neben der OLED selbst.

Vorteile ergeben sich unter anderem durch neue Gestaltungsmöglichkeiten in Fahrzeugleuchten, insbesondere Heckleuchten. Darüber hinaus sind Mehrfachfunktionen möglich, die für bestimmte Geometrienanordnungen der OLEDs ansonsten nicht ohne weiteres erfüllt werden können, wie etwa Seitenmarkierungslichtfunktion und Schlusslichtfunktion. Darüber hinaus kann gezielt eine Abstrahlung beispielsweise von rotem Licht nach vorne durch entsprechende Ausgestaltung der Auskoppeloptik 25 oder durch Verwendung opaken Materials in entsprechenden Bereichen der Kunststoffhalterung 03 verhindert werden.

Die Erfindung nutzt das am Außenrand eines OLED-Plättchens 02 abgestrahlte Licht zur Erfüllung einer Lichtfunktion mit vorgegebener Lichtverteilung oder zumindest zu deren Beitrag, indem das am Außenrand austretende Licht durch die Auskoppeloptik 25 in eine gewünschte Richtung umgelenkt wird.

Die Erfindung erweitert hierdurch den Einsatzbereich von als OLED-Plättchen 02 ausgeführten OLEDs 20, indem eine wenigstens einen Teil deren Kanten einnehmende, angespritzte, kurz als Halter bezeichnete Kunststoffhalterung 03 zumindest in den wenigstens einen Teil des die Kanten umfassenden Rands 23 einnehmenden Bereichen aus einem zumindest im für das menschliche Auge sichtbaren Teil des elektromagnetischen Spektrums transparenten Material hergestellt ist. Der Halter ist in seinen wenigstens einen Teil des die Kanten umfassenden Rands 23 einnehmenden Bereichen aus einem zumindest im für das menschliche Auge sichtbaren Teil des elektromagnetischen Spektrums transparenten Material mit angeformten Auskoppeloptiken 25 versehen. Die Auskoppeloptiken 25 lenken das an den Kanten austretende Licht in solche Raumwinkelbereiche ab oder um, dass das dort austretende Licht beim Verlassen der Fahrzeugleuchte einer vorgegebenen Lichtverteilung beiträgt und/oder nicht in solchen Raumwinkelbereichen die Fahrzeugleuchte verlässt, in denen kein Licht einer bestimmten Lichtfunktion und Farbe austreten darf.

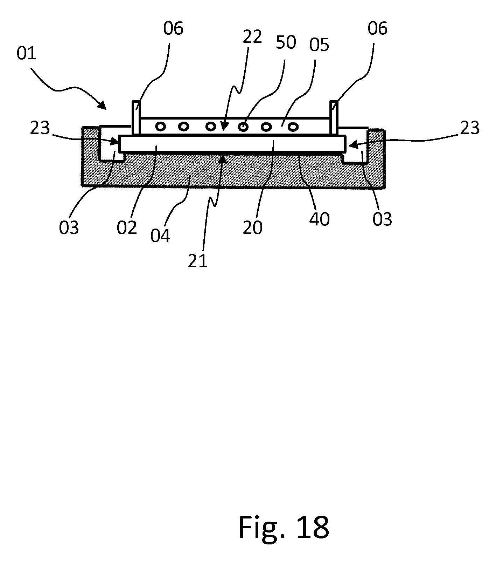

Ein Verfahren zur Herstellung eines zuvor beschriebenen, mindestens eine in Form eines OLED-Plättchens 02 ausgeführte OLED 20 als Lichtquelle umfassenden Leuchtmittels 01 sieht vor, dass:
- zunächst mindestens ein OLED-Plättchen 02 in eine Ausnehmung einer Form 04 eingelegt wird, welche Form 04 mindestens eine in der Ausnehmung ausgebildete Auflage 40 für jedes OLED-Plättchen 02 aufweist, und welche Ausnehmung in mindestens einer sich parallel zur Vorderseite 21 und Rückseite 22 des OLED-Plättchens 02 erstreckenden Richtung ein Maß aufweist, das größer ist, als die Erstreckung des OLED-Plättchens 02 in dieser Richtung (Fig. 18),
- anschließend das OLED-Plättchen 02 mit zunächst flüssigem Kunststoff umspritzt und/oder umgossen wird, wobei die Ausnehmung der Form 04 mit dem darin eingelegten OLED-Plättchen 02 mit dem zunächst flüssigen Kunststoff verfüllt wird,
- daraufhin abgewartet wird, bis der anfänglich flüssige Kunststoff verfestigt, und
- schließlich das mindestens ein zumindest an einem Teil seines umlaufenden Rands 23 von einer Kunststoffhalterung 03 umspritztes oder umgossenes OLED-Plättchen 02 umfassende Leuchtmittel 01 der Form entnommen wird.

Die Auskoppeloptik 25 kann vermittels anschließende Laserstrukturierung der Kunststoffhalterung 03 hergestellt sein.

Alternativ oder zusätzlich kann vorgesehen sein, die Kunststoffhalterung 03 durch Hinterspritzung einer in die Ausnehmung der Form einzulegende Folie herzustellen, welche Folie mit einer eine Auskoppeloptik 25 bildenden, vorgefertigten, beispielsweise durch Drucken und/oder Stanzen und/oder Tiefziehen hergestellten Struktur versehen sein kann.

Die mindestens eine Auflage 40 kann eine einer Lichtabgabe dienende oder zur Lichtabgabe vorgesehene Vorderseite 21 oder Rückseite 22 des OLED-Plättchens 02 bildende Oberfläche des OLED-Plättchens 02 ganz oder teilweise einnehmen, wobei das OLED-Plättchen 02 hierbei mit der entsprechenden Oberfläche auf die mindestens eine Auflage 40 in der Ausnehmung der Form 04 aufgelegt wird.

Bevorzugt wird das OLED-Plättchen 02 zumindest während des Einbringens des zunächst flüssigen Kunststoffs in die Ausnehmung sowie während des Abwartens der Verfestigung des Kunststoffs gekühlt. Hierdurch kann verhindert werden, dass die mindestens eine organische Schicht der OLED 20 des OLED-Plättchens 02 weder durch das Einbringen eines gegebenenfalls durch Erhitzen verflüssigten Kunststoffs in die Ausnehmung, noch durch einen gegebenenfalls stattfindenden exothermen chemischen Abbindevorgang während des Abwartens der Verfestigung des zumindest anfangs flüssigen Kunststoffs beschädigt wird.

Zur Kühlung des OLED-Plättchens 02 zumindest während des Einbringens des zunächst flüssigen Kunststoffs in die Ausnehmung sowie während des Abwartens der Verfestigung des Kunststoffs kann vorgesehen sein, dass die mindestens eine Auflage 40, auf der das OLED-Plättchen 02 in der Ausnehmung der Form 04 aufliegt, in wämeübertragender Verbindung mit einer Wärmesenke steht oder in solche Verbindung bringbar ist. Beispielsweise kann die Auflage 40 in wämeübertragender Verbindung mit einer Wärmesenke stehen, indem sie gekühlt ist, etwa durch einen in die Auflage 40 eingearbeiteten Kanal eines Kühlkreislaufs, durch den ein Kühlmittel hindurchströmen, beispielsweise zirkulieren kann.

Eine alternative oder zusätzliche Möglichkeit zur Kühlung des OLED-Plättchens 02 zumindest während des Einbringens des zunächst flüssigen Kunststoffs in die Ausnehmung sowie während des Abwartens der Verfestigung des Kunststoffs ist in Fig. 18 dargestellt. Hierbei erfolgt die Kühlung durch einen Stempel 05, der vor dem Einbringen des zunächst flüssigen Kunststoffs auf zumindest einen Teil der der mindestens einen Auflage 40 abgewandten Oberfläche des OLED-Plättchens 02 abgesenkt wird und in dieser Position verweilt, bis der Kunststoff verfestigt ist. Der Stempel 05 kann gekühlt sein, beispielsweise passiv durch Ausnutzung dessen Wärmekapazität, wobei er wenn er nicht auf ein OLED-Plättchen 02 abgesenkt ist, in ein kühleres Wärmeniveau zurückgezogen wird, oder aktiv, wobei der Stempel 05 mit einer Wärmesenke in wämeübertragender Verbindung steht, beispielsweise indem in den Stempel 05 mindestens ein Kanal 50 eines Kühlkreislaufs eingearbeitet ist, durch den ein Kühlmittel hindurchströmen, beispielsweise zirkulieren kann.

Alternativ oder zusätzlich kann die Auflage 40 derart ausgebildet sein, dass das OLED-Plättchen 02 an mindestens einem Randbereich auf der Auflage 40 aufliegt. Ein entsprechender, auf der Auflage 40 aufgelegter Randbereich bleibt hierbei frei von der Umspritzung oder Umgießung vermittels der Kunststoffhalterung 03.

Wichtig ist in diesem Zusammenhang zu erwähnen, dass das OLED-Plättchen 02 bevorzugt frei von Kräften und Momenten auf die mindestens eine Auflage 40 in der Ausnehmung der Form 04 aufgelegt wird und nur durch Formgebung der Ausnehmung der Form 04 und der Auflage 40 während des Umspritzens und/oder Umgießens ortsfest gehalten wird.

Der Kunststoff kann durch Aufheizen in seinen zunächst flüssigen Zustand versetzt sein, wobei die Verfestigung durch eine Abkühlung erreicht wird.

Alternativ oder zusätzlich kann ein chemischer Abbindevorgang während der Verfestigung des zunächst flüssigen Kunststoffs stattfinden.

Das Verfahren kann vorsehen vor dem Umspritzen und/oder Umgießen des OLED-Plättchens 02 die Ausnehmung der Form 04 bis auf wenigstens eine Eintragungs- oder Einbringungsöffnung für den zunächst flüssigen Kunststoff und bis auf wenigstens eine Austragungs- oder Entweichungsöffnung für von dem zunächst flüssigen Kunststoff während dessen Einbringens in die Ausnehmung verdrängte Luft zu verschließen. Die dabei verbleibende, die Ausnehmung umfassende oder von der Ausnehmung umfasste Kavität weist eine der äußeren Gestalt des fertigen Leuchtmittels entsprechende Geometrie auf.

Das Verfahren kann zusätzlich vorsehen, dass die Ausnehmung der Form 04 eine Tiefe aufweist, welche größer ist, als eine der Erstreckung des OLED-Plättchens 02 von dessen Vorderseite 21 zu dessen Rückseite 22 normal zu Vorderseite 21 und Rückseite 22 entsprechende Dicke des OLED-Plättchens 02, wobei die Ausnehmung während des Umspritzens und/oder Umgießens bis über das OLED-Plättchen 02 gefüllt wird.

Das Verfahren kann vorsehen, vor oder nach dem Einlegen des OLED-Plättchens 02 in die Form elektrische Anschlüsse der OLED 20 beispielsweise durch Drahtbonden oder ACF-Bonden zu kontaktieren und mit der Weiterkontaktierung dienenden Leitern zu verbinden. Die Leiter können aus der Ausnehmung der Form 04 heraus geführt werden, bevor in einem späteren Verfahrensschritt das OLED-Plättchen 02 mit zunächst flüssigem Kunststoff umspritzt und/oder umgossen wird.

Alternativ kann das Verfahren vor oder nach dem Einlegen des OLED-Plättchens 02 in die Ausnehmung der Form 04 vorsehen, die elektrischen Anschlüsse der OLED 20 des OLED-Plättchens 02 mit einer nachträglich entfernbaren Abdeckung zu bedecken und dadurch zu schützen und von dem in einem späteren Verfahrensschritt, in dem das OLED-Plättchen 02 mit zunächst flüssigem Kunststoff umspritzt und/oder umgossen wird, in die Ausnehmung verfüllten Kunststoff freizuhalten.

Das Verfahren kann alternativ oder zusätzlich vorsehen, gegebenenfalls mit elektrischen Anschlüssen der OLED 02 des des OLED-Plättchens 02 verbundene oder verbindbare Leiterbahnen in die Ausnehmung einzubringen, welche dann in einem späteren Verfahrensschritt, in dem das OLED-Plättchen 02 mit zunächst flüssigem Kunststoff umspritzt und/oder umgossen wird, ebenfalls von dem Kunststoff umspritzt und/oder umgossen werden.

Grundsätzlich kann das Verfahren zur gleichzeitigen Ausbildung von Leiterbahnen auf oder in der durch Umspritzen und/oder Umgießen des OLED-Plättchens 02 mit zunächst flüssigem Kunststoff hergestellten Kunststoffhalterung 03 eine oder mehrere Methoden der MID-Technik vorsehen, wie etwa Zweikomponentenspritzguss, MID-Heißprägen, Laser-Direkt-Strukturierung, Subtraktive Laserstrukturierung, Maskenbelichtungsverfahren, Folienhinterspritzen, Aufschmelzen eines kontinuierlich zugeführten Kupferdrahts und Aufspritzen auf die Trägermaterialien mit Druckluft. Die elektrischen Anschlüsse der OLED 20 können im Anschluss an die Herstellung der Leiterbahnen beispielsweise durch Drahtbonden oder ACF-Bonden mit zumindest einem Teil der Leiterbahnen verbunden werden.

Wichtig ist hervorzuheben, dass wenn das Leuchtmittel 01 mehrere OLED-Plättchen 02 umfasst, diese bevorzugt voneinander beabstandet und zumindest durch einen Steg der Kunststoffhalterung 03 voneinander getrennt sind.

Die Erfindung schafft eine kunststofftechnische Aufnahme von Glaskörpern oder Körpern, die Glasteile oder mindestens teilweise transparente oder teiltransparente Kunststoffe beinhalten, insbesondere OLEDs 20, vorzugsweise in Fahrzeugleuchten. Die Aufnahme erfolgt hierbei mittels eines Kunststoffumgieß- und/oder -umspritzprozesses.

Die zumindest an ihrer Vorderseite 21 und/oder Rückseite 22 beispielsweise mit Glasplättchen zu deren Verkapselung versehene und dadurch einen Glaskörper im Sinne der voranstehenden Ausführung darstellende OLED 20 wird mit Hilfe eines Umgießprozess und/oder Umspritzprozess mit Kunststoff gehalten und kann damit an weitere Teile der Fahrzeugleuchte angebunden werden oder sein.

Wichtig ist nachfolgendes hervorzuheben.

Die Darstellungen in Fig. 1 bis Fig. 6 sowie Fig. 9 bis Fig. 17 zeigen den Aufbau mit einer von der Kunststoffhalterung 03 nicht vollständig am Rand umfassten, als ein OLED-Plättchen 02 ausgeführten OLED 20. Vorteilhaft ist hierbei ein filigraneres und damit hochwertigeres Erscheinungsbild. Weiterhin liegt ein eine Glaskante 24 darstellender Teil des Rands 23 frei. Dieser kann beispielsweise für weitere Lichtfunktionen verwendet werden, wie etwa eine Seitenmarkierungslichtfunktion, deren Hauptabstrahlwinkelbereich 90° zur Hauptabstrahlrichtung einer Schlusslichtfunktion gedreht ist. Daher kann die Lichtauskopplung an dieser Glaskante 24 für eine andere Funktion verwendet werden.

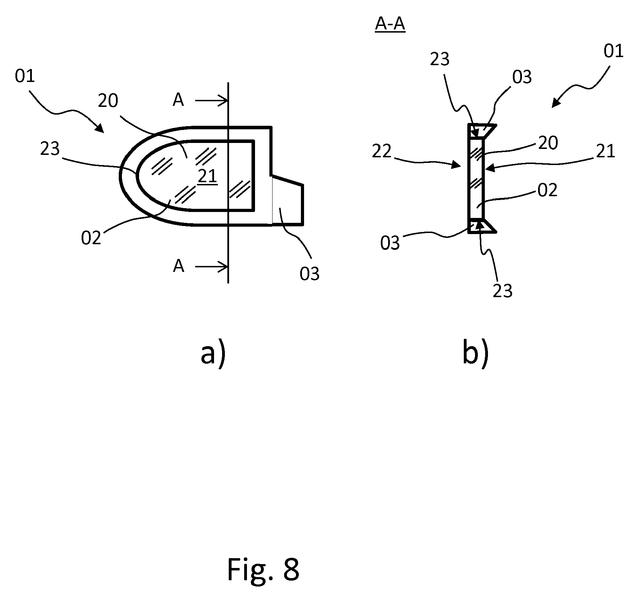

Das Umspritzen und/oder Umgießen des OLED-Plättchens 02 kann vollflächig geschehen, wobei die Rückseite 22 des OLED-Plättchens 02 in die Kunststoffhalterung 03 mit einbezogen ist. Die Kunststoffhalterung 03 kann weiterhin ringförmig, C-förmig oder in einer anderen umgreifenden Form, wie dies in Fig. 7 und Fig. 8 dargestellt ist ausgeführt sein.

Bei einer Umspritzung oder Umgießung ausschließlich des Rands 23 eines OLED-Plättchens 02 wie in Fig. 8 dargestellt, kann vorteilhaft ein Effekt eines leichten Schrumpfens des anfangs flüssigen Kunststoffs bei dessen Verfestigung genutzt werden, um das OLED-Plättchen sicher zu fassen.

Die Kunststoffhalterung 03 kann mittels Umspritzen und/oder Umgießen ausgeführt werden oder mittels einer Kombination von beidem. Auch kann die Kunststoffhalterung 03 das OLED-Plättchen 02 zumindest teilweise an dessen Vorderseite 21 und/oder Rückseite 22 haltern und/oder das OLED-Plättchen 02 zumindest teilweise am Rand 23 fassen.

Vorteilhaft ist es, die OLED 20 vor hohen Temperaturen bei der Herstellung zu schützen, da deren organische Schichten durch Temperatureinfluss altern oder irreversibel geschädigt werden.

Als Faustformel lässt sich feststellen, dass je höher die Temperatur an der OLED 20 ist, desto schneller die OLED 20 altert. Dieser Prozess verläuft annähernd exponentiell mit der Temperatur, wobei die OLED 20 bei hohen Temperaturen viel schneller altert als bei niedrigen Temperaturen. Durch die Alterung verliert die OLED 20 an Leuchtdichte bei konstant angelegtem Strom. Darüber hinaus erhöht sich die Vorwärtsspannung der OLED 20. Das bedeutet auch, dass die Effizienz der OLED 20 mit der Alterung abnimmt.

Nachteilig ist hierbei auch, dass die Leuchtenelektronik die höhere Vorwärtsspannung bereitstellen muss.

Bei Termperaturen ab etwa 105°C...125°C können organische Schichten irreversibel geschädigt werden, so dass diese nicht mehr zur Lichtemission anregbar sind und die OLED 20 somit lichttechnisch zerstört ist.

Daher ist es vorteilhaft, die organischen Schichten möglichst kühl zu halten und von einer beispielsweise heißen Kunststoffschmelze mit Temperaturen von mehreren 100°C bei der Herstellung fern zu halten. Eine Werkzeugkühlung im Bereich der organischen Schichten kann hier vorteilhaft sein, wie in Fig. 18 dargestellt.

Hierbei kann, wie in Fig. 18 dargestellt, eine Trennung und/oder Beabstandung zwischen heißen und gekühlten Partien des OLED-Plättchens 02 erfolgen, beispielsweise indem noch vor dem Verfüllen der Form 04 mit dem zunächst flüssigen Kunststoff zwischen die mit einer Wärmesenke in wärmeübertragender Verbindung stehenden Elemente Auflage 40 und/oder Stempel 05 eine Trennschicht 06 eingebracht wird. Hierdurch werden Wärmespannungen im OLED-Plättchen verringert oder sind gar vermeidbar.

Wichtig ist hervorzuheben, dass wenn in den voranstehenden Ausführungen von einem einer Verkapselung dienenden anorganischen Material und/oder von Glas und/oder von Glasplättchen die Rede ist, dies beispielhaft für eine von vielen möglichen und denkbaren Ausgestaltung eines OLED-Plättchens zu verstehen ist. Die Erfindung bietet ebenso einen verbesserten Schutz nebst allen erwähnten Vorteilen für solche OLED-Plättchen, die mit einem anderen Material als einem anorganischen oder mit einem anderen anorganischen Material als Glas oder als Metall an ihrer Vorder- 21 und/oder Rückseite 22 versehen sind.

Denkbar ist beispielsweise eine Verkapselung unter Verzicht auf anorganische Materialien, die mit Poymeren verwirklicht ist.

Die Erfindung ist nicht durch die Beschreibung anhand der Ausführungsbeispiele beschränkt. Vielmehr umfasst die Erfindung jedes neue Merkmal sowie jede Kombination von Merkmalen, was insbesondere jede Kombination von Merkmalen in den Ansprüchen beinhaltet, auch wenn dieses Merkmal oder diese Kombination selbst nicht explizit in den Ansprüchen oder Ausführungsbeispielen angegeben ist.

Die Erfindung ist insbesondere im Bereich der Herstellung von Fahrzeugleuchten, insbesondere Fahrzeugleuchten, sowie Komponenten von Fahrzeugleuchten, wie etwa Lichtquellen und/oder ein oder mehrere Elektronikbauteile und/oder Lichtquellen umfassenden Leuchtmitteln gewerblich anwendbar.

### Bezugszeichenliste

- 01: Leuchtmittel
- 02: OLED-Plättchen
- 03: Kunststoffhalterung
- 04: Form
- 05: Stempel
- 06: Trennschicht
- 20: OLED
- 21: Vorderseite
- 22: Rückseite
- 23: Rand
- 24: Glaskante
- 25: Auskoppeloptik
- 30: Fließhilfe
- 40: Auflage
- 50: Kanal

## Patentansprüche

1. Leuchtmittel (01) mit mindestens einer OLED (20) als Lichtquelle, wobei die OLED (20) aus wenigstens einem Stapel umfassend organisch halbleitende Materialien mit mindestens einer zwischen elektrisch leitenden Schichten für Anode und Kathode eingeschlossen Emitterschicht besteht und Teil eines OLED-Plättchens (02) ist, bei dem der wenigstens eine Stapel zumindest vorder- und rückseitig verkapselt ist, und welches OLED-Plättchen (02) eine Vorderseite (21 ), eine Rückseite (22) sowie einen dessen Vorder- und Rückseite (21, 22) verbindenden Rand (23) aufweist, wobei das OLED-Plättchen (02) zumindest an einem Teil seines Rands (23) von einer Kunststoffhalterung (03), welche wenigstens zum Teil aus einem zumindest im für das menschliche Auge sichtbaren Teil des elektromagnetischen Spektrums transparenten Material besteht, umspritzt und/oder umgossen ist, und an der das OLED-Plättchen (02) zumindest an einem Teil seines Rands (23) umgebenden Kunststoffhalterung (03) mindestens eine Auskoppeloptik (25) angeordnet ist.

2. Leuchtmittel nach Anspruch 1, wobei zur vorder- und/oder rückseitigen Verkapselung der OLED (20) Glasplättchen dienen.

3. Leuchtmittel nach Anspruch 1 oder 2, wobei das OLED-Plättchen (02) in einer Draufsicht normal zur Vorder- und Rückseite (21, 22) des OLED-Plättchens (02) von zwei Seiten her L-förmig von der Kunststoffhalterung (03) umspritzt und/oder umgossen ist.

4. Leuchtmittel nach Anspruch 1 oder 2, wobei das OLED-Plättchen (02) in einer Draufsicht normal zur Vorder- und Rückseite (21, 22) des OLED-Plättchens (02) von zwei gegenüberliegenden Seiten her von der Kunststoffhalterung (03) umspritzt und/oder umgossen ist.

5. Leuchtmittel nach Anspruch 1 oder 2, wobei das OLED-Plättchen (02) in einer Draufsicht normal zur Vorder- und Rückseite (21, 22) des OLED-Plättchens (02) von drei Seiten her C-förmig von der Kunststoffhalterung (03) umspritzt und/oder umgossen ist.

6. Leuchtmittel nach Anspruch 1 oder 2, wobei das OLED-Plättchen (02) in einer Draufsicht normal zur Vorder- und Rückseite (21, 22) des OLED-Plättchens (02) allseitig um dessen gesamten Rand (23) herum von der Kunststoffhalterung (03) umspritzt und/oder umgossen ist.

7. Leuchtmittel nach einem der voranstehenden Ansprüche, wobei das OLED-Plättchen (02) vorder- oder rückseitig ganz oder teilweise von der Kunststoffhalterung (03) umspritzt und/oder umgossen ist.

8. Leuchtmittel nach einem der voranstehenden Ansprüche, wobei auch eine einer Lichtabgabe dienende oder zur Lichtabgabe vorgesehene Vorder- und/oder Rückseite (21, 22) des OLED-Plättchens (02) jeweils ganz oder teilweise von der Kunststoffhalterung (03) umspritzt und/oder umgossen ist.

9. Leuchtmittel nach einem der voranstehenden Ansprüche, wobei Fließhilfen (30) an der Kunststoffhalterung (03) vorgesehen sind.

10. Leuchtmittel nach einem der voranstehenden Ansprüche, wobei die Kunststoffhalterung (03) als ein in MID-Technik hergestellter Leiterbahnträger ausgeführt ist, zumindest ein Teil dessen Leiterbahnen mit elektrischen Anschlüssen der OLED (20) des mindestens einen OLED-Plättchens (02) elektrisch verbunden und/oder elektrisch verbindbar sind.
